# EUROPÄISCHE PATENTSCHRIFT

(11) **EP 1 646 150 B1**
(45) Veröffentlichungstag und Bekanntmachung des Hinweises auf die Patenterteilung: **14.02.2007**
(21) Anmeldenummer: 06000022.1
(22) Anmeldetag: 23.12.2003
(51) Int. Cl.: H03L 7/085, H04L 7/04

(54) **Verfahren und Vorrichtung zum Extrahieren einer einem Datenstrom zugrundeliegenden Taktfrequenz**
Method and device for extracting a clock pulse frequency underlying a data flow
Procédé et dispositif pour extraire une fréquence d'horloge à la base d'un flux de données

(30) Priorität: 23.12.2002 DE 10260656
(43) Veröffentlichungstag der Anmeldung: 12.04.2006
(62) Teilanmeldung aus: 03799504.0
(73) Patentinhaber: Infineon Technologies AG, 81669 München (DE)
(72) Erfinder: Greco, Patrizia, 9524 St. Magdalen (AT); Steinschaden, Andreas, 9587 Riegersdorf (AT); Thaller, Edwin, 9583 Faak/See (AT); Zessar, Gernot, 9531 Kreuth (AT)
(74) Vertreter: Stöckeler, Ferdinand

(56) Entgegenhaltungen:
- EP-A- 0 414 445
- US-A- 4 320 391
- US-A- 6 125 158
- US-B1- 6 407 641

## Beschreibung

In der Datenübertragungstechnik besteht generell der Bedarf, einen Takt aus einem Datenstrom zu extrahieren. Ein Datenübertragungsstandard, der in letzter Zeit starke Verbreitung erfahren hat, ist der USB-Standard (USB = Universal Serial Bus). Der USB-Standard standardisiert ein Datenübertragungsformat zur schnellen Datenübertragung zwischen USB-Geräten und einem Host. Der USB-Standard definiert eine sogenannte Tier-Star-Topologie, wobei USB-Geräte entweder Hubs oder Funktionen bzw. Funktionsgeräte sein können. Das USB-Datenformat ist in der USB-Spezifikation spezifiziert. Die aktuellste USB-Definition ist gerade USB-Revision 2.0.

Der USB-Bus ist ein Halb-Duplex-Bus. Alle Transaktionen werden von dem Host initiiert. In der USB-Spezifikation-Revision 2.0 sind drei Datenübertragungsraten definiert. Die niedrigste Datenübertragungsrate wird im Low-Speed-Modus verwendet, und beträgt 1,5 Megabit pro Sekunde. Im Full-Speed-Modus wird eine Datenübertragungsrate von 12 Megabit pro Sekunde verwendet. Im High-Speed-Modus wird eine Datenübertragungsrate von 480 Megabit pro Sekunde eingesetzt.

Die Verwendung des Low-Speed-Modus dient für interaktive Geräte, wie z. B. eine Tastatur oder eine Maus. Nur eine begrenzte Anzahl von Low-Speed-Geräten sollte mit dem Bus verbunden sein, um eine Degradation der Bus-Ausnutzung zu vermeiden. Für Full-Speed- und High-Speed-Geräte sind eine spezielle Bandbreite und Latenzzeit garantiert.

Geräte sind mit dem USB-Bus über ein 4-Draht-Kabel verbunden, das Differenzdaten, ein Leistungssignal und Masse trägt. Dies bedeutet, daß eine Ader des 4-Draht-Kabels ein positives Differenzsignal Dp trägt, daß eine weitere Ader des 4-Draht-Kabels ein negatives Differenzsignal Dn trägt, daß eine weitere Ader auf dem Versorgungspotential liegt und daß schließlich die letzte Ader auf dem Massepotential liegt. Die Taktinformationen sind in den Daten codiert. Gemäß der USB-Spezifikation wird eine NRZI-Codierung und eine Bit-Stuffing-Technik verwendet, um eine adäquate Anzahl von Übergängen zu garantieren. NRZI bedeutet No Return to Zero Invert. Dies bedeutet, daß eine inverse Codierung eingesetzt wird. Ein logisches "1"-Signal wird durch einen niedrigen Spannungszustand dargestellt, während ein logisches "0"-Signal durch eine hohe Spannung dargestellt wird. Darüber hinaus findet zwischen zwei aufeinanderfolgenden "0"-Zuständen oder zwei aufeinanderfolgenden "1"-Zuständen keine Rückkehr auf 0 statt.

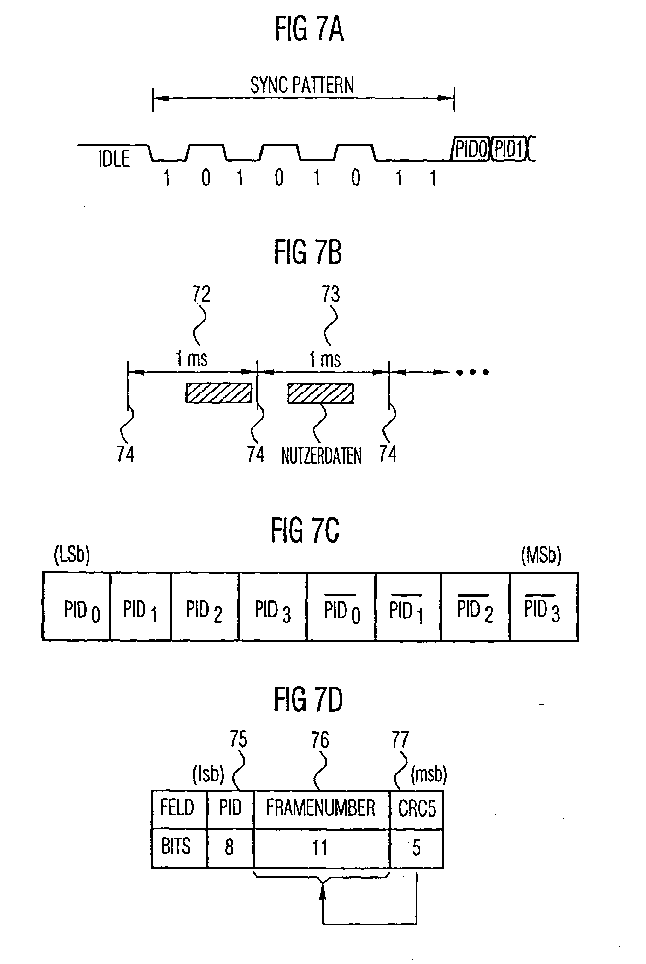

Wie es in Fig. 7b dargestellt ist, ist der Datenstrom als eine Folge von Rahmen oder Frames 72, 73 definiert, die durch sogenannte Ticks 74 voneinander getrennt sind, wobei die Ticks in einem Abstand von 1 ms auftreten. Innerhalb des Rahmens 72 oder 73 befindet sich eine Mehrzahl von Datenpaketen. Dies bedeutet, daß ein Rahmen aus mehreren Datenpaketen besteht, und daß sich ein Datenstrom aus einer Mehrzahl aufeinanderfolgender Rahmen zusammensetzt. Jedes Datenpaket wird im Datenstrom von einer Paketidentifikationsnummer eingeleitet, die eine Breite von 8 Bits hat und in Fig. 7c dargestellt ist. Ein Rahmen umfaßt daher so viele Paketidentifikationsnummern (PID), wie Pakete in dem Rahmen vorhanden sind. Die in Fig. 7c dargestellte Spezifikation der Paketidentifikationsnummer, die vier Bits breit ist und in einem PID-Feld durch die vier PID-Bits PID₀, PID₁, PID₂, PID₃ und durch die entsprechend invertierten PID-Bits dargestellt ist, ist im USB-Standard festgelegt. Die Bits, die in Fig. 7c dargestellt sind, sind vom LSb bis zum MSb angeordnet. LSb steht für niederstwertiges Bit (Least Significant Bit), während MSb für höchstwertiges Bit (Most Significant Bit) steht.

Der Host überträgt ein Rahmenstart-Paket (SOF-Paket; SOF = Start of Frame) einmal pro Millisekunde, um die in Fig. 7b dargestellten Ticks 74 zu definieren. Das SOF-Paket ist in Fig. 7d dargestellt und umfaßt ein SYNC-Feld (in Fig. 7d nicht dargestellt), ein SOF-PID-Feld 75, eine 11-Bit-Rahmennummer (76) (Frame Number) sowie einen CRC 5-Fingerabdruck über das Feld 76, der in einem Feld 77 eingetragen ist. Die Rahmennummer 76 wird mit jedem zusätzlichen SOF-Paket um 1 inkrementiert.

In Fig. 7a ist das beispielsweise dem PID-Feld 75 von Fig. 7d vorausgehende Synchronisationsmuster (SYNC-Pattern) dargestellt. Es besteht aus einer im USB-Standard spezifizierten Folge von Bits bzw. einem Datenmuster, das aufgrund der NRZI-Codierung derart aussieht, wie es in Fig. 7a dargestellt ist. Die Folge von Bits beträgt 10101011. Vor dem Synchronisationsdatenmuster ist ein mit Idle bezeichneter Bereich, der im Hinblick auf die Differenzsignale Dp und Dm eine Single-Ended-Zero (SE0) Codierung aufweist, wie es nachfolgend dargelegt wird. Diese SE0-Codierung der Dp- und Dm-Signale weist auf das Ende eines vorhergehenden Rahmens hin und weist ferner darauf hin, daß nunmehr ein neuer Rahmen folgt, der mit einem Synchronisationsfeld eingeleitet wird, dem unmittelbar, wie es in Fig. 7a gezeigt ist, die Paketidentifikationsnummer und im speziellen, wie es in Fig. 7c gezeigt ist, ein niederstwertiges Bit der PID gefolgt von dem nächsthöherwertigen Bit der PID etc. folgt.

Die in Fig. 7a gezeigte Notation illustriert, daß die Bits im Synchronisationsmuster festgelegt sind und nur die Folge von 10101011 haben können, während die PID-Bits sowohl eine 0 als auch eine 1 je nach zu codierender Paketidentifikation haben können.

Jedes Low-Speed- oder Full-Speed-Datenpaket, das über den USB-Bus übertragen wird, startet also mit einem Synchronisationsmuster (Fig. 7a), dem die Paket-Identifikationsnummer (PID) folgt, die in Fig. 7c dargestellt ist, welche den Pakettyp definiert. Das Synchronisationsfeld umfaßt eine Serie von 0-1-Übergängen auf dem Bus, um es einem Empfänger zu ermöglichen, sich auf den Bittakt zu synchronisieren.

Wie es in Fig. 7 dargestellt ist, ist ein Rahmenintervall von einer Millisekunde definiert. Der Host überträgt ein SOF-Paket (Rahmenstartpaket) einmal pro Millisekunde (Fig. 7b). Das SOF-Paket besteht aus einem Synchronisationsfeld, gefolgt von der SOF-PID, einer 11-Bit-Rahmennummer und einem CRC 5-Fingerabdruck (Fig. 7d). Die Rahmennummer wird mit jedem gesendeten SOF-Paket inkrementiert.

Wenn ein Gerät mit dem USB-Bus verbunden wird, findet eine Hochfahr-Sequenz statt. Am Ende dieser Sequenz wird das Gerät in einen Reset-Zustand getrieben. Nach dem Reset-Ereignis hat das Gerät eine Zeitdauer von 10 Millisekunden, um ein Reset-Recovery durchzuführen. Während dieser Zeit empfängt das Gerät SOF-Pakete.

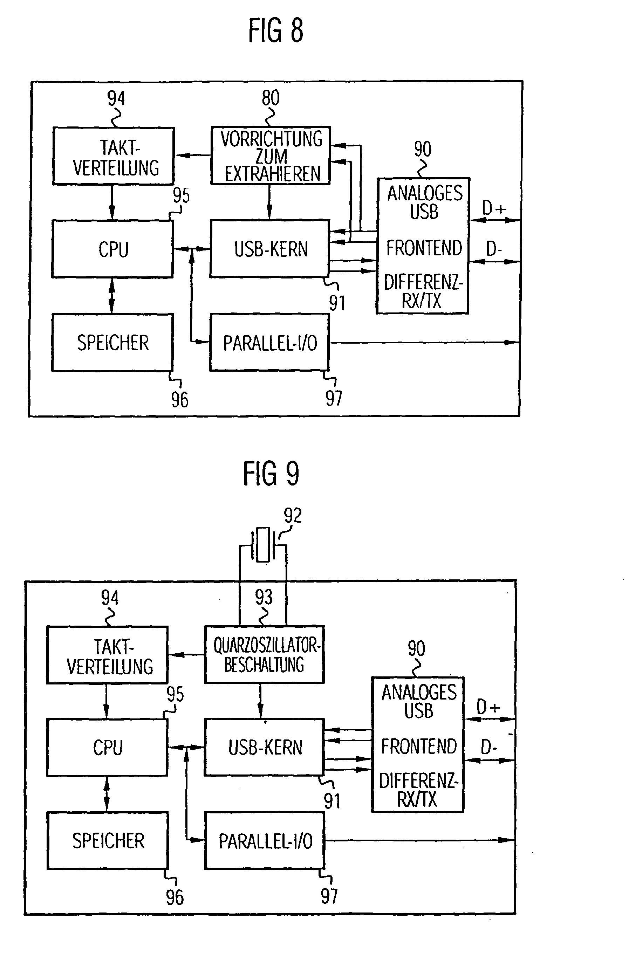

Ein herkömmliches USB-Gerät ist in Fig. 9 schematisch dargestellt. Es umfaßt ein analoges USB-Frontend, das mit einem Differenz-Sender (TX) und einem Differenz-Empfänger (RX) in einer Funktionseinheit 90 integriert sein kann. An einer Seite des Elements 90 liegen die Signale Dp und Dm in analoger Form dar, während an einer anderen Seite des Elements 90 die entsprechenden empfangenen und analog/digital gewandelten Signale anliegen, die in einen USB-Kern 91 eingespeist werden bzw. von demselben empfangen werden. Diese Signale sind in Fig. 9 durch die zwei Paare von parallelen Signalpfeilen dargestellt. Das USB-Gerät umfaßt ferner einen Quarzoszillator 92, der mit einer Quarzoszillatorbeschaltung 93 in Verbindung steht, wobei die Quarzoszillatorbeschaltung 93 einerseits den USB-Kern 91 und andererseits eine Taktverteilung 94 ansteuert, die mit einer CPU 95 verbunden ist, welche wiederum mit einem Speicher 96 in Wirkverbindung steht. Ferner umfaßt ein USB-Gerät je nach Anwendung auch eine Parallel-Eingabe-Ausgabe-Schnittstelle (Parallel-I/O) 97.

Solche herkömmlichen USB-Geräte verwenden, wie es aus Fig. 9 ersichtlich ist, typischerweise einen Quarzoszillator 92 als Taktquelle für die Systemgeräte und die USB-Datenwiederherstellungsschaltung. Für robuste tragbare Geräte, wie z. B. Chipkarten, würde es wünschenswert sein, daß sie ihren eigenen lokalen Takt direkt aus dem USB-Datenstrom extrahieren. Für solche Geräte ist die Verwendung von Quarzoszillatoren unpraktisch, da Quarze normalerweise nicht in einen Chip integriert werden können und ferner für eine Zerstörung aufgrund mechanischer Belastungen sehr anfällig sind. Chipkarten werden üblicherweise in rauhen Umgebungen getragen, wie z. B. in einem Portemonnaie, das in einer Hosentasche untergebracht ist. Der dadurch ausgeübte mechanische Streß wäre für einen Schwingquarz fatal.

Daher wurden Takterzeugungsschaltungen für USB-Geräte im Low-Speed-Modus entwickelt, die keine Quarzoszillatoren benötigen.

Die US 2001/0011914 A1 offenbart eine Vorrichtung für die Wiedergewinnung eines Taktsignals aus zumindest zwei Synchronisationsbits. Als Referenztaktsignal wird ein Signal von einem inneren Oszillator verwendet, um die Anzahl von Referenztaktpulsen zwischen den ersten zwei Synchronisationspulsen zu messen, die von einem externen USB-Bus am Beginn jeder Transaktion gesendet werden. Damit wird eine Grobmessung N für das USB-Taktsignal, das regeneriert werden soll, erhalten. Die Verzögerung von jedem dieser zwei Synchronisationspulse bezüglich des vorhergehenden Pulses des Referenztaktsignals wird gemessen. Diese Verzögerung wird bezüglich einer intern definierten Zeiteinheit berechnet. Auf der Basis der Messung dieser zwei Verzögerungen und der Messung einer Anzahl von Referenztaktperioden.

Die US 2001/0020857 A1 offenbart eine Vorrichtung für die Regeneration eines Taktsignals aus einem externen seriellen Bus, wobei die Vorrichtung einen Ringoszillator und einen Zähler aufweist. Der Ringoszillator liefert n Phasen eines Taktsignals. Von diesen n-Phasen wird eine Phase als Referenz verwendet und an den Zähler angelegt. Es ist daher möglich, die Anzahl von gesamten Referenztaktsignalperioden zwischen einem ersten Puls und einem zweiten Puls, welche von dem Bus erhalten werden, zu zählen. Beim Lesen des Zustands der Phasen in dem Oszillator beim Empfang des zweiten Pulses wird eine aktuelle Phase bestimmt, die der Phasenverschiebung zwischen dem Referenztaktsignal und dem zweiten Puls des Busses entspricht. Unter Verwendung einer Regenerationsvorrichtung, die ebenfalls einen Ringoszillator und einen Zähler umfaßt, ist es möglich, das Taktsignal auf dem Bus mit hoher Genauigkeit zu regenerieren.

Das U.S.-Patent Nr. 6,343,364 B1 offenbart ein Verfahren und eine Vorrichtung zur Lokaltakterzeugung unter Verwendung der USB-Signale Dp und Dm, das ohne Schwingquarz oder Resonator arbeitet. Hierzu wird eine Anzahl von Zyklen eines freilaufenden Hochfrequenztaktsignals gezählt, welche in einer bekannten Anzahl von Bitperioden des empfangenen Signals auftritt. Hierauf wird die gezählte Anzahl von Zyklen des freilaufenden Hochfrequenzsignals durch die bekannte Anzahl von Bitperioden geteilt, um eine resultierende Anzahl von Taktzyklen zu bestimmen, die in einer einzigen Bitdauer des empfangenen USB-Signals enthalten sind. Darauf aufbauend wird ein Lokaltaktsignal erzeugt.

Die WO 00/16255 offenbart ein Verfahren zur Datenübertragung und eine hierfür geeignete Smart Card. Die Signale Dp und Dm sind mit einer Schnittstelle der Karte verbunden. Die Karte umfaßt ferner eine CPU, Speichereinheiten, USB-Ausgangskontakte sowie eine Anordnung von zumindest sechs Kontaktflächen, die mit der Oberfläche des Kartenkörpers eben sind.

Das U.S.-Patent Nr. 5,487,084 offenbart ein Konzept zum Erzeugen einer Taktfrequenz in einer Smart-Card-Schnittstelle, die zur Datenübertragung von einer Smart-Card zu beispielsweise einem Mobiltelephon verwendet wird, um eine vorbestimmte Datenrate zu erhalten. Eine Phasenregelschleife und eine Anzahl von programmierbaren Zählern wird eingesetzt, um ein Taktsignal mit einer Frequenz zu erhalten, die ein Vielfaches der Datenrate ist. Insbesondere können die Zähler und die Phasenregelschleife so gewählt werden, daß die Frequenz das 16-fache einer solchen Datenrate beträgt, um einen universellen asynchronen Empfänger/Sender (UART) einsetzen zu können.

Das U.S.-Patent Nr. 5,818,948 offenbart eine Architektur für ein USB-basiertes PC-Lautsprecher-Steuerungsgerät. Zur Wiedergewinnung eines Takts aus dem empfangenen Datenstrom wird eine Phasenregelschleife eingesetzt.

Das U.S.-Patent Nr. 6,061,802 offenbart eine Softwarebasierte Taktsynchronisation mit einer isochronen Master-Taktstruktur, in der die Rahmenratentakte einer Mehrzahl von Datenbussen auf ein Mastertaktsignal synchronisiert sind. Das Mastertaktsignal wird von den existierenden Taktsignalen innerhalb des Computersystems oder aus Daten, die von einer externen Quelle empfangen werden, abgeleitet.

Das U.S.-Patent Nr. 6,092,210 offenbart eine Vorrichtung und ein Verfahren zum Synchronisieren der Takte von verbundenen USB-Bussen, indem Takte in einem lokalen Gerät auf die Datenströme beider USB-Busse synchronisiert werden. Hierzu wird eine separate Lokaltaktsynchronisationsvorrichtung für jedes USB-Gerät eingesetzt, das mit dem betrachteten USB-Gerät verbunden ist. Jede getrennte Lokaltaktsynchronisation kann denselben Referenztakt verwenden.

Ähnliche Taktwiedergewinnungssysteme, wie sie in den oben beschriebenen Referenzen dargestellt sind, verwenden das Synchronisationsmuster (Fig. 7a), das jedem USB-Datenpaket vorausgeht. Dies mag für Low-Speed-USB-Anwendungen hinsichtlich der Genauigkeit genügen. Für schnellere Anwendungen im USB-Full-Speed-Modus oder im USB-High-Modus ist die Genauigkeit des Synchronisationsmusters zu klein. Dies wird anhand der folgenden Zahlenbeispiele dargestellt. Für Full-Speed-USB-Geräte besteht die Anforderung dahingehend, daß der Sendetakt auf 0,25% (2500 ppm) genau sein muß. Aufgrund des großen Zeit-Jitters, das bei 12 ns für Paar-Übergänge (Paired Transitions) liegt bzw. bei 20 ns für aufeinanderfolgende Übergänge (Consecutive Transitions) liegt, das für die seriellen Bitdaten auf dem USB-Bus zugelassen ist, ist eine zuverlässige Taktwiedergewinnung allein aufgrund des Synchronisationsmusters nicht möglich.

Das US-Patent Nr. 6,407,641 B1 offenbart einen Auto-Locking-Oszillator für die Datenkommunikation. Zum Abstimmen der Oszillationsfrequenz eines Taktsignals wird die Frequenz eines ankommenden Datenstroms analysiert, um eines oder mehrere Steuersignale zu erzeugen, und wird die Oszillationsfrequenz entsprechend auf das eine oder die mehreren Signale eingestellt. Zwischen einem Datenstromanalysator und dem einzustellenden Oszillator sind eine Grobabstimmungseinrichtung und eine Feinabstimmungseinrichtung geschaltet.

Das US-Patent Nr. 6,125,158 offenbart eine Phasenregenschleife und einen Multistufen-Phasenkomparator. Der Komparator misst eine Phasendifferenz zwischen einem Referenzsignal und einem Ausgangssignal unter Verwendung eines periodischen Takts. Der Komparator ist ein Zwei-Stufen-Komparator mit einem Fein-Komparator und einem Grob-Komparator. Der Grob-Komparator misst die Anzahl von Taktperioden zwischen den Übergängen des Referenzsignals und des Ausgangssignals. Der Fein-Komparator umfasst einen Verzögerungsleitungs-Generator der eine Mehrzahl von verzögerten Takten erzeugt. Diese werden dann verwendet, um das Referenzsignal abzutasten, um eine Fein-Phasendifferenz zwischen Übergängen des Referenzsignals und des Ausgangssignals zu bestimmen.

Die EP 0414445 A2 offenbart einen digitalen Frequenzsynthesizer mit einem Phasenakkumulator, der einen Grob-Komponentenakkumulator und einen Fein-Komponenten-Akkumulator zusammen mit einer Dithering-Schaltung umfasst. Der Fein-Komponenten-Akkumulator steuert den Grob-Komponenten-Akkumulator, der wiederum einen nicht-linearen DAW speist.

Die Aufgabe der vorliegenden Erfindung besteht darin, ein einerseits wirtschaftliches und andererseits genaues Konzept zum Extrahieren einer einem Datenstrom zugrundeliegenden Taktfrequenz zu schaffen.

Diese Aufgabe wird durch eine Vorrichtung gemäß Patentanspruch 1 oder ein Verfahren gemäß Patentanspruch 12 oder ein Computer-Programm gemäß Patentanspruch 13 gelöst.

Der vorliegenden Erfindung liegt die Erkenntnis zugrunde, daß auch für schnellere USB-Modi das Synchronisationsfeld alleine bzw. die Zeitdauer des Synchronisationsfelds wenigstens ausreichend ist, um eine Grobeinstellung eines in Grenzen freilaufenden Oszillators zu erreichen. Die damit erreichbare Genauigkeit für die Einstellung des freilaufenden Oszillators ist jedoch viel zu gering, um eine sinnvolle Datenextraktion durchzuführen. Sie ist jedoch bereits ausreichend genau, um mit einer Grob-Datenwiedergewinnung zu starten, um das Paketidentifikationsfeld, das auf das Synchronisationsfeld folgt, zu decodieren. Erfindungsgemäß wird die Anzahl von Taktperioden des freilaufenden Oszillators zwischen zwei zeitlich aufeinanderfolgenden Paketidentifikationsfeldern gezählt und mit einem vorbestimmten Referenzwert verglichen.

Die vorliegende Erfindung basiert somit darauf, daß, obgleich ein Zeit-Jitter für aufeinanderfolgende USB-Takte von 12 ns bzw. 20 ns zugelassen ist, die Genauigkeit für ein Rahmenintervall, also für den Abstand zwischen zwei aufeinanderfolgenden Rahmenstart-Paketidentifikationen prozentual gesehen wesentlich enger vorgegeben ist. So ist beim USB-Standard ein Rahmenintervall auf 1 ms ±500 ns definiert. Dies entspricht einer relativen Genauigkeit von 0,05%. Erfindungsgemäß wird daher die mit hoher relativer Genauigkeit vorliegende Rahmenperiode verwendet, um eine Feineinstellung des Taktwiedergewinnungsoszillators zu erreichen.

An dieser Stelle sei darauf hingewiesen, daß die Feinabstimmung auf der Basis der Rahmenperiode, also dem ersten Datenmuster bei einem bevorzugten Ausführungsbeispiel erst erfolgt, nachdem die Grobabstimmung auf der Basis des Synchronisationsfelds stattgefunden hat, da bei dem bevorzugten Ausführungsbeispiel eine Rahmenidentifikationsnummerndecodierung gut funktioniert, nachdem eine Grobabstimmung stattgefunden hat.

Das erfindungsgemäße Konzept ist dahingehend vorteilhaft, daß eine zweischrittige Vorgehensweise angewandt wird, bei der die Feinabstimmung auf der Grobabstimmung aufbaut und damit ohne externe Schwingquarze oder aufwendige nichtintegrierbare Resonatoren eine Taktwiedergewinnung auch für Geräte ermöglicht, die mit schnellen Datenraten arbeiten, wie z. B. dem USB-High-Speed-Modus oder USB-Full-Speed-Modus.

Das erfindungsgemäße Konzept ist ferner dahingehend vorteilhaft, daß der Einsatz einfacher und damit robust arbeitender Algorithmen möglich ist, so daß eine einfache und gleichzeitig robuste Implementierung z. B. auf tragbaren Geräten wie Chipkarten etc. möglich ist, die auch hinsichtlich der Rechenleistung und hinsichtlich des Speicherbedarfs per se begrenzt sind.

Erfindungsgemäß wird somit auf der Basis eines in dem Datenstrom vorhandenen zweiten Datenmusters, das vorzugsweise einfach detektierbar ist, eine Grobabstimmung vorgenommen, und wird auf der Basis von in dem Datenstrom wiederkehrenden ersten Datenmustern eine Feinabstimmung durchgeführt, wobei die wiederkehrenden ersten Datenmuster mit hoher Genauigkeit vorliegen, jedoch nicht derart einfach detektierbar sind wie ein zweites Datenmuster. Damit wird eine Taktwiedergewinnung mit der hohen Genauigkeit, die dem wiederkehrenden ersten Datenmuster in dem Datenstrom zugrunde liegt, erreicht, zu dessen Detektion jedoch eine Grobabstimmung des Oszillators auf der Basis des zwar einfach detektierbaren jedoch ungenau vorliegenden zweiten Datenmusters verwendet wird.

Bevorzugte Ausführungsbeispiele der vorliegenden Erfindung werden nachfolgend Bezug nehmend auf die beiliegenden Zeichnungen detailliert erläutert. Es zeigen:
- Fig. 1: ein Blockdiagramm einer erfindungsgemäßen Vorrichtung zum Extrahieren einer einem Datenstrom zugrundeliegenden Taktfrequenz;
- Fig. 2: ein detailliertes Blockdiagramm der Grobabstimmungseinrichtung von Fig. 1;
- Fig. 3: ein detailliertes Blockdiagramm der Feinabstimmungseinrichtung von Fig. 3;
- Fig. 4: ein Blockschaltbild des Konzepts zum iterativen Grob- bzw. Feinabstimmen gemäß einem bevorzugten Ausführungsbeispiel der vorliegenden Erfindung;
- Fig. 5: ein Blockschaltbild einer erfindungsgemäßen Vorrichtung zum Extrahieren gemäß einem bevorzugten Ausführungsbeispiel der vorliegenden Erfindung;
- Fig. 6: ein Flußdiagramm zur Erläuterung des bei dem in Fig. 5 dargestellten Ausführungsbeispiels verwendeten Iterationsverfahrens;
- Fig. 7a: einen Ausschnitt des Datenstroms mit Synchronisationsmuster und nachfolgendem PID-Muster;
- Fig. 7b: eine Darstellung der Organisation des Datenstroms in Frames;
- Fig. 7c: eine Darstellung der in dem Datenstrom enthaltenen PID gemäß dem USB-Standard;
- Fig. 7d: eine Darstellung der Rahmenstart-PID gemäß dem USB-Standard;
- Fig. 8: ein Blockschaltbild eines USB-Geräts mit einer erfindungsgemäßen Vorrichtung zum Extrahieren; und
- Fig. 9: ein Blockschaltbild eines USB-Geräts mit einem externen Quarzoszillator.

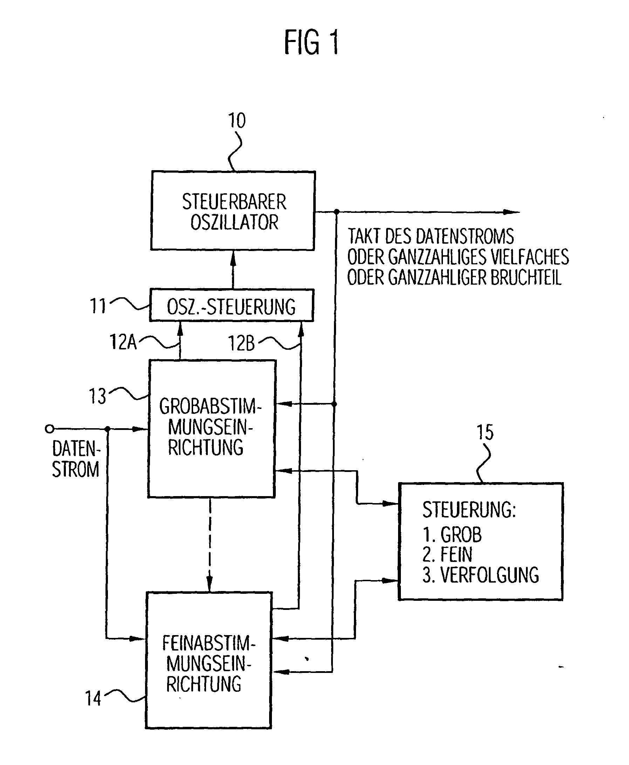

Fig. 1 zeigt eine Vorrichtung zum Extrahieren einer einem Datenstrom zugrundeliegenden Taktfrequenz, wobei der Datenstrom in regelmäßigen, mit einer relativen ersten Genauigkeit spezifizierten ersten zeitlichen Abständen, wie z. B. 1 ms bei einer Anwendung für einen USB-Datenstrom, ein erstes Datenmuster, wie z. B. eine Rahmenstart-Paketidentifikationsnummer (SOF-PID) aufweist, und wobei der Datenstrom ferner ein zweites Datenmuster (Synchronisations-Feld) aufweist, das eine Mehrzahl von Taktperioden gemäß der Taktfrequenz oder einem Vielfachen der Taktfrequenz aufweist, wobei die Taktperioden mit einer zweiten relativen Genauigkeit spezifiziert sind, die kleiner als die erste relative Genauigkeit ist.

Die erfindungsgemäße Vorrichtung ist ausgebildet, um einen steuerbaren Oszillator 10 anzusteuern, d. h. um eine Oszillator-Steuerung 11 mit Grobabstimmungssignalen auf einer Leitung 12a oder Feinabstimmungssignalen auf einer Leitung 12b zu beliefern, derart, daß die Oszillatorsteuerung 11 dem steuerbaren Oszillator 10 je nach Ausführung des steuerbaren Oszillators ein entsprechendes Spannungssignal im Falle eines VCO oder ein entsprechendes Stromsignal im Falle eines ICO zuführen kann.

Die erfindungsgemäße Vorrichtung umfaßt eine Grobabstimmungseinrichtung 13 und eine Feinabstimmungseinrichtung 14. Die Grobabstimmungseinrichtung ist ausgebildet, um einen Beginn und ein Ende des zweiten Datenmusters (Synchronisationsfeld am Beispiel der USB-Spezifikation) zu detektieren. Die Grobabstimmungseinrichtung ist ferner ausgebildet, um eine Anzahl von Taktperioden des steuerbaren Oszillators 10 in einer Zeitdauer von dem Beginn zu dem Ende des zweiten Datenmusters zu zählen. Darüber hinaus ist die Grobabstimmungseinrichtung ausgebildet, um in dem Fall, in dem die gezählte Anzahl größer als ein Referenzwert ist, die Einrichtung 11 zur Oszillatorsteuerung anzusteuern, um die Oszillatortaktfrequenz des steuerbaren Oszillators 10 zu verringern, oder in dem Fall, in dem die gezählte Anzahl kleiner als der Referenzwert ist, den steuerbaren Oszillator anzusteuern, um dessen Oszillatortaktfrequenz zu erhöhen.

Analog hierzu ist die Feinabstimmungseinrichtung 14 ausgebildet. Im Unterschied zur Grobabstimmungseinrichtung detektiert sie jedoch nicht den Beginn und das Ende des zweiten Datenmusters sondern das Auftreten eines ersten Datenmusters im Datenstrom und ein zeitlich folgendes Auftreten des ersten Datenmusters im Datenstrom.

Die Feinabstimmungseinrichtung ist ferner ausgebildet, um die Anzahl von Taktperioden des Oszillators 10 von einem Auftreten des ersten Datenmusters bis zu einem nächsten Auftreten des ersten Datenmusters zu zählen, um dann je nach Lage des gezählten Werts bezüglich eines eingestellten Referenzwerts die Oszillatorsteuerungseinrichtung 11 anzusteuern, damit die Schwingfrequenz des steuerbaren Oszillators 10 erhöht bzw. erniedrigt wird.

Dadurch wird eine Oszillatortaktfrequenz mit der relativen zweiten Genauigkeit, also der Genauigkeit, die dem ersten Datenmuster zugrunde liegt, erhalten, die, je nach spezifischer Ausführung, unmittelbar gleich dem Takt ist, der dem Datenstrom zugrunde liegt, oder gleich einem Vielfachen des Takts ist, der dem Datenstrom zugrunde liegt, oder gleich einem Bruchteil des Takts ist, der dem Datenstrom zugrunde liegt. Insbesondere werden ganzzahlige Vielfache, wie z. B. das Zweifache, Dreifache, .... n-fache bevorzugt, wobei n eine ganze Zahl ist. Bezüglich der Bruchteile werden ebenfalls ganzzahlige Bruchteil bevorzugt, wie z. B. 1/2, 1/3, 1/4, ...., 1/n, wobei n ebenfalls eine ganze Zahl ist.

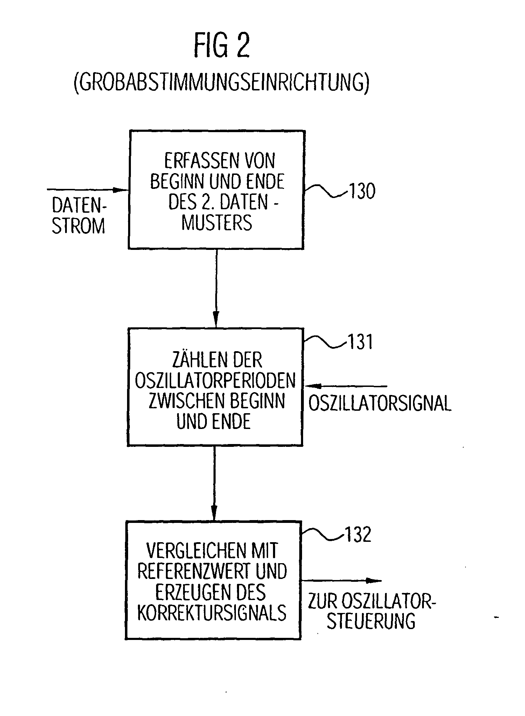

Fig. 2 zeigt ein detaillierteres Blockdiagramm der Grobabstimmungseinrichtung von Fig. 1. Im einzelnen umfaßt die Grobabstimmungseinrichtung 13 von Fig. 1 eine Einrichtung 130 zum Erfassen des Beginns und des Endes des zweiten Datenmusters im Datenstrom, also am Beispiel des USB-Datenstroms z. B. den Beginn des Synchronisationsmusters in Form der ersten logischen "1" und das Ende des Synchronisationsmusters in Form der letzten "1" des Synchronisationsmusters von Fig. 7a. In Ausführungsform und Implementation kann jedoch auch nur ein Teil des Synchronisationsmusters von Fig. 7a als zweites Datenmuster verwendet werden, so daß das zweite Datenmusters, das zu Grobabstimmungszwecken verwendet wird, mit der ersten logischen "1" beginnt und mit der dritten logischen "0" endet, derart, daß nur der alternierende Teil des Synchronisationsmusters von Fig. 7a verwendet wird. Wieder alternativ könnte auch lediglich abhängig von dem Verhältnis der Frequenz des steuerbaren Oszillators zu dem in Fig. 7a verwendeten Bittakt auch nur ein Teil des alternierenden Bitmusters eingesetzt werden.

Ansprechend auf die Einrichtung 130 wird eine Einrichtung 131 zum Zählen der Oszillatorperioden zwischen dem von der Einrichtung 130 erfaßten Beginn und dem von der Einrichtung 130 erfaßten Ende betrieben. Im einzelnen wird durch ein Zähleraktivierungssignal, das die Einrichtung 130 ausgibt, wenn sie den Beginn des zweiten Datenmusters detektiert hat, ein Zähler gestartet, der die Taktperioden des der Einrichtung 131 zugeführten Oszillatorsignals so lange zählt, bis von der Einrichtung 130 das Ende erfaßt wird oder entsprechend das Zähler-Stop-Signal von der Einrichtung 130 zu der Einrichtung 131 übermittelt wird.

Der Zählerstand kann dann von der Einrichtung 131 einer Einrichtung 132 zugeführt werden, die ausgebildet ist, um den Zählerstand mit einem Referenzwert zu vergleichen, und um ein entsprechendes Korrektursignal zu liefern, das zur Oszillatorsteuerung (Einrichtung 11 von Fig. 1) übermittelt wird. Der von der Einrichtung 132 verwendete Referenzwert hängt von einer Nennfrequenz des Oszillators 10 und einer zeitlichen Dauer bzw. Anzahl von betrachteten Bits des in Fig. 7a dargestellten Synchronisationsmusters oder eines Teils desselben ab. Beträgt der Bittakt des Synchronisationsmusters in Fig. 7a z. B. 12 Megabit pro Sekunde im Full-Speed-USB-Modus, und liegt die Nennfrequenz des steuerbaren Oszillators beispielsweise bei 96 MHz, also dem acht-fachen des Full-Speed-USB-Takts, und wird das gesamte Synchronisationsfeld, also die 8 Bittakte zur Grobabstimmung verwendet, so wird in diesem Fall der vorbestimmte Referenzwert gleich 64 sein. Dies bedeutet, daß im Falle einer optimalen Oszillatoreinstellung der steuerbare Oszillator 10 während der Dauer des Synchronisationsmusters von Fig. 7a 64 Takte liefern müßte. Liefert er weniger als 64 Takte, so ist er zu langsam. Liefert er dagegen mehr als 64 Takte, so ist zu schnell.

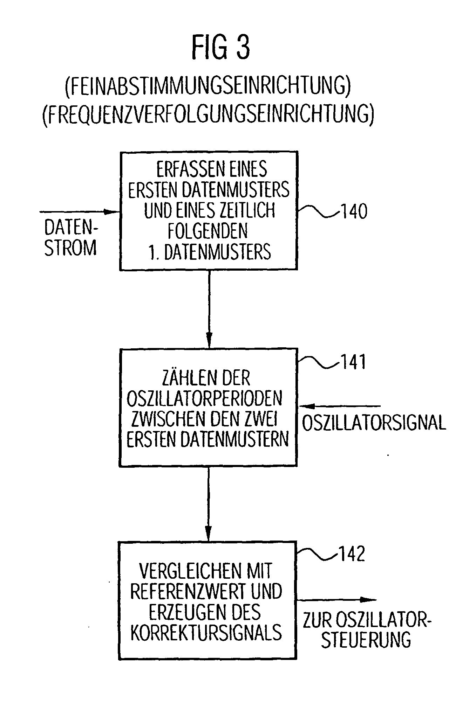

Fig. 3 zeigt ein detaillierteres Blockdiagramm der Feinabstimmungseinrichtung 14 von Fig. 1. Die Feinabstimmungseinrichtung 14 von Fig. 1 umfaßt eine Einrichtung 140 zum Erfassen eines ersten Datenmusters (einer SOF-PID am Beispiel des USB-Formats) und eines zeitlich folgenden ersten Datenmusters. Beim Erfassen eines ersten Datenmusters wird ein Zähler in einer Einrichtung 141 zum Zählen der Oszillatorperioden bei einem ersten Datenmustern aktiviert, der dann, wenn ein zeitlich folgendes erstes Datenmuster detektiert worden ist, wieder angehalten wird. Der Zähler in der Einrichtung 141 ist wirksam, um die Taktperioden des steuerbaren Oszillators 10 von Fig. 1 zu zählen. Der Zählwert wird dann einer Einrichtung 142 zugeführt, die ausgebildet ist, um diesen Zählwert mit einem Referenzwert zu vergleichen und das Korrektursignal zu erzeugen, das der Oszillatorsteuerung 11 von Fig. 1 zugeführt wird.

Am Beispiel eines USB-spezifizierten Datenstroms ist der zeitliche Abstand zwischen zwei aufeinanderfolgenden ersten Datenmustern 1 ms, wie es in Fig. 7b gezeigt ist. Beträgt die Nennfrequenz des steuerbaren Oszillators 10 von Fig. 1 wieder 96 MHz, so wäre in diesem Fall der vorbestimmte Referenzwert 96.000, d. h. es müßten 96.000 Oszillatorzyklen in dem Zeitraum von 1 Millisekunde auftreten, damit der Oszillator korrekt eingestellt ist. Ist der Zählwert größer als 96, so muß die Oszillatorfrequenz reduziert werden. Ist der Zählwert dagegen kleiner als 96, so muß die Oszillatorfrequenz erhöht werden.

Die in Fig. 3 gezeigte Feinabstimmungseinrichtung kann ferner als Frequenzverfolgungseinrichtung eingesetzt werden, nachdem sowohl die Grobabstimmung als auch die Feinabstimmung beendet sind und die Genauigkeit bzw. die Frequenzfolgefähigkeit des Oszillators weiter gesteigert werden soll, wie es nachfolgend noch erläutert wird.

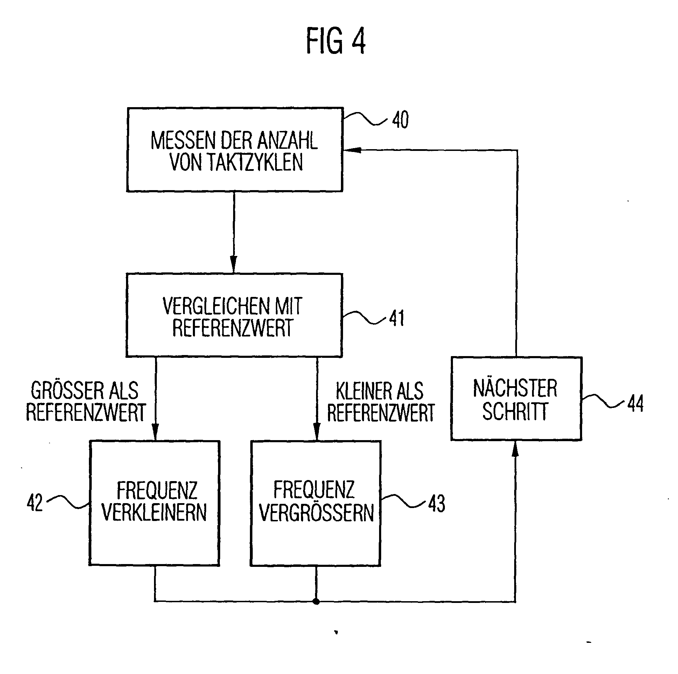

Die Einrichtungen 132 von Fig. 2 bzw. 142 von Fig. 3 sind vorzugsweise ausgebildet, um iterativ zu arbeiten, wie es anhand von Fig. 4 nachfolgend erläutert wird. Die iterative Vorgehensweise besteht darin, zunächst die Anzahl der Taktzyklen durch die Einrichtungen 130 bzw. 140 zu messen (40), um die gemessene Anzahl dann mit einem Referenzwert zu vergleichen (41). Ist das Vergleichsergebnis dahingehend, daß die Anzahl von Taktzyklen größer als der Referenzwert ist, so wird die Frequenz verkleinert (42). Wird dagegen festgestellt, daß die gemessene Anzahl von Taktzyklen kleiner als der Referenzwert ist, so muß die Frequenz des Oszillators vergrößert werden (43). Dann wird eine Iterationsvariable inkrementiert bzw. wird in einen nächsten Schritt 44 eingetreten, in dem nunmehr wieder überprüft wird, ob die im letzten Wert vergrößerte oder verkleinerte Frequenz wiederum zu hoch oder zu niedrig ist.

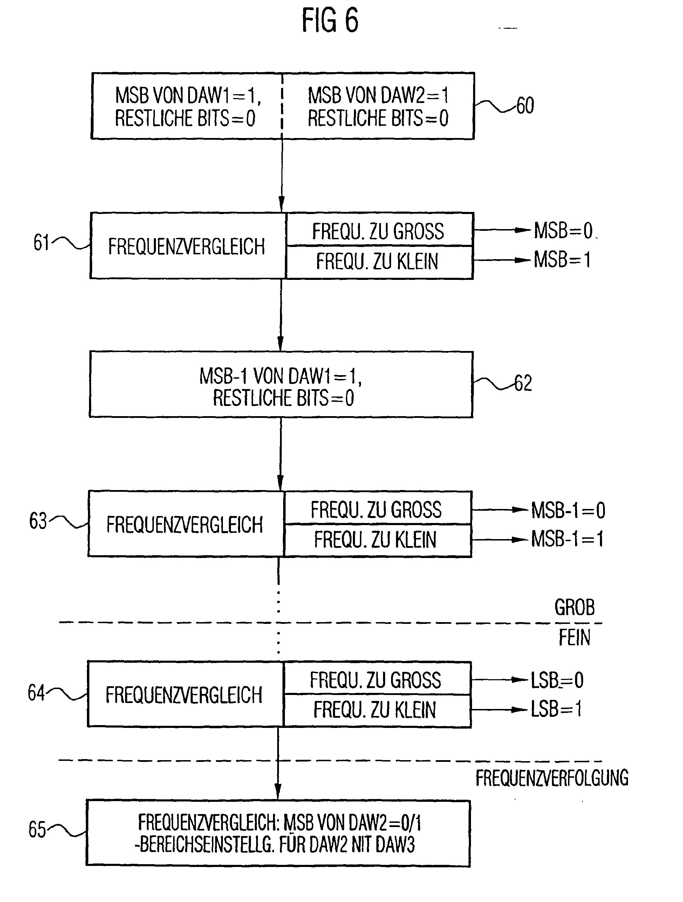

Als Iterationsstrategie bzw. als Inkrementwert, mit dem die Frequenz in einem Schritt zum nächsten erhöht bzw. erniedrigt wird, können verschiedene Strategien eingesetzt werden. Erfindungsgemäß wird es bevorzugt, ein Konzept einzusetzen, bei dem der Inkrementbetrag, um den die Frequenz von einem Schritt zum nächsten verändert wird, also erhöht bzw. erniedrigt wird, sich von Schritt zu Schritt verändert und insbesondere sich von Schritt zu Schritt verkleinert. Hierzu wird es bevorzugt, ein Verfahren der sukzessiven Approximation einzusetzen, das später anhand der Fig. 6 näher erläutert wird.

Bei dem bevorzugten Ausführungsbeispiel der vorliegenden Erfindung wird das 1 ms-Rahmenintervall zum Einstellen der Frequenz des freilaufenden Oszillators eingesetzt. Innerhalb von 10 Rahmenintervallen ist die Frequenzgenauigkeit des Oszillators innerhalb des spezifizierten Bereichs von 0,25%. Hierzu wird, wie es ausgeführt worden ist, eine Abstimmung des Oszillators in zwei Abschnitten durchgeführt, nämlich zunächst in einem Grobabstimmungsabschnitt und dann in einem Feinabstimmungsabschnitt.

Für die Grobeinstellung wird die Anzahl von Oszillatorperioden zwischen einer bestimmten Anzahl von SYNC-Feld-Bits gezählt und mit einem Referenzwert verglichen. Wenn der Zählerwert größer als der Referenzwert ist, ist die Oszillatorfrequenz zu hoch und wird verringert. Ist dagegen der Zählerwert kleiner als der Referenzwert, so ist die Oszillatorfrequenz zu niedrig und wird erhöht. Wenn die Anzahl von Grobabstimmungsschritten gleich C beträgt, wenn der Referenzwert mit CR bezeichnet ist und wenn der Zählerwert mit CC bezeichnet wird, und wenn schließlich die Frequenz des Oszillators v beträgt, so kann der Grobabstimmungsalgorithmus folgendermaßen allgemein dargestellt werden:
1. Messen von CC_{C}(v_{C-1})
2. CC_{C} > CR : ν_{C} = ν_{C-1} Δν_{C}
   CC_{C} < CR : ν_{C} = ν_{C-1} Δν_{C} usw.
3. Messen von CC_{C+1} (ν_{C})

Nach einer bestimmten kleinen Anzahl von Grobabstimmungsschritten kann die Messung auf der Basis von SYNC-Bits die Genauigkeit der Oszillatorfrequenz nicht weiter verbessern. Nun beginnt die Feinabstimmung.

Zur Feinabstimmung wird die Anzahl von Oszillatorperioden zwischen SOF-Paketen gezählt, und es wird ein Algorithmus, der ähnlich dem Grobabstimmungsalgorithmus ist, eingesetzt. Wenn die Feinabstimmungs-Schritt-Nummer F beträgt, der Referenzwert FR beträgt, der Zählerwert FC beträgt und die Frequenz des Oszillators wieder v ist, ergibt sich der Feinabstimmungsalgorithmus folgendermaßen:
(a) Messen von FC_{F}(ν_{F-1})
(b) FC_{F} > FR : V_{F} = ν_{F-1} Δν_{F}
   FC_{F} < FR : ν_{F} = ν_{F-1} Δν_{F} usw.
(c) Messen von FC_{F+1}(V_{F})

Da die Zeit zwischen aufeinanderfolgenden SOF-Paketen auf ±500 ns genau ist, wird eine Genauigkeit der eingestellten Frequenz von 0,5% (500 ppm) erreicht.

Die Frequenz des Oszillators nach der Abstimmung desselben wird durch den Referenzwert FR bestimmt. Wenn die erwünschte Oszillatorfrequenz beispielsweise 96 MHz beträgt, muß der Referenzwert FR gleich 96.000 sein, wenn aufeinanderfolgende SOF-Pakete betrachtet werden. Werden nicht unmittelbar aufeinanderfolgende SOF-Pakete betrachtet, sondern z. B. zweifach, bzw. dreifach aufeinanderfolgende SOF-Pakete, so ist der Referenzwert entsprechend höher. Im Falle von Halben, Dritteln, Vierteln, ... der Periodendauer zwischen SOF-Paketen ist der Referenzwert entsprechend niedriger.

Wie es bereits anhand der Fig. 3 dargestellt worden ist, findet nach der Feinabstimmung bei einem bevorzugten Ausführungsbeispiel der vorliegenden Erfindung ein Frequenzverfolgungsalgorithmus statt, der die Oszillatorfrequenz weiter einstellt. Wie im Feinabstimmungsalgorithmus wird die Anzahl von Oszillatorperioden zwischen im Datenstrom vorhandenen SOF-Paketen gemessen.

Der Oszillatortakt, der nach der Grobabstimmung und nach der Feinabstimmung erhalten wird, kann beispielsweise als Referenztakt für einen USB-Kern verwendet werden. Hierzu wird auf Fig. 8 verwiesen, in der die erfindungsgemäße Vorrichtung zum Extrahieren, die mit 80 bezeichnet ist, dargestellt ist. Die erfindungsgemäße Vorrichtung zum Extrahieren besitzt daher zusammen mit einem steuerbaren Oszillator die Funktionalität der Blöcke 92 und 93 der bekannten USB-Funktionsschaltung, die anhand von Fig. 9 erläutert worden ist.

Es sei darauf hingewiesen, daß ein Phäsen-Locking zwischen dem Oszillatortakt und dem Bittakt des USB-Datenstroms nicht nötigt ist, da die Oszillatortaktfrequenz üblicherweise ein Vielfaches der Bittaktfrequenz ist und ein Oversampling und digitale PLLs zur Datenwiedergewinnung verwendet werden können.

Die erfindungsgemäße Vorrichtung ist dahingehend vorteilhaft, daß für Datenströme, denen ein schneller Takt zugrunde liegt, wie z. B. für Full-Speed-USB-Datenströme und High-Speed-USB-Datenströme, kein Quarzoszillator benötigt wird. Natürlich werden auch für langsamer getaktete Datenströme keine externen Oszillatoren benötigt.

Die erfindungsgemäße Vorrichtung ist ferner dahingehend vorteilhaft, da die regenerierte Frequenz mit hoher Genauigkeit erhalten wird, die durch die Genauigkeit bestimmt ist, mit der das erste Datenmuster im Datenstrom vorhanden ist. Am Beispiel der USB-Anwendung wird eine Genauigkeit von 0,05% erreicht.

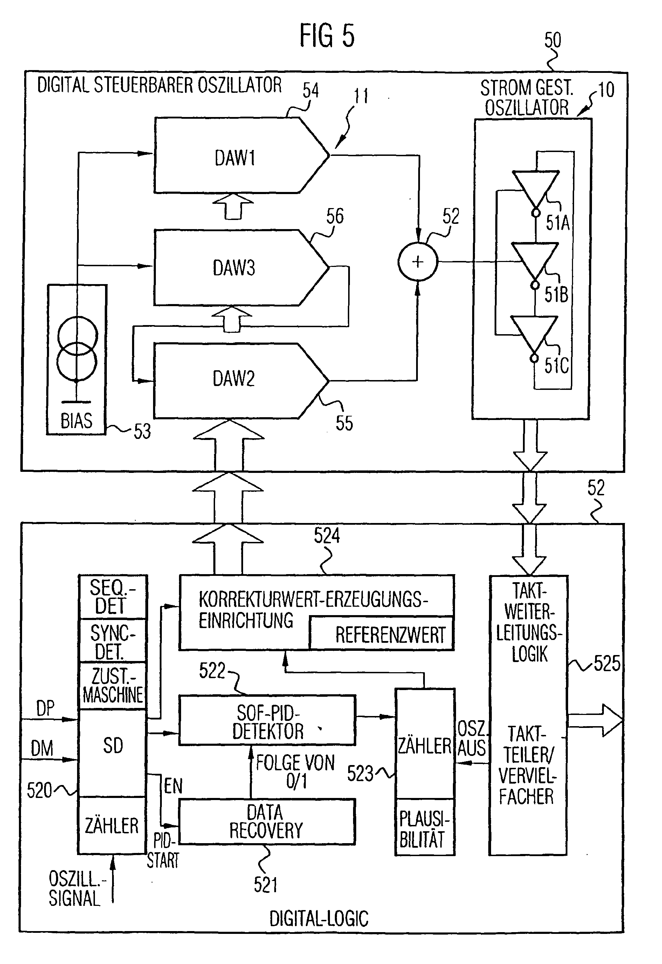

Nachfolgend wird Bezug nehmend auf Fig. 5 ein bevorzugtes Ausführungsbeispiel der vorliegenden Erfindung im Blockdiagrammform dargestellt. Fig. 5 zeigt eine Taktregenerationsschaltung, die prinzipiell aus zwei Haupteinheiten besteht. Die eine ist der digital steuerbare Oszillator 50, der eine Oszillatorsteuerung 11 einerseits und den steuerbaren Oszillator 10 andererseits aufweist, der in Fig. 5 ein stromgesteuerter Oszillator ist.

Fig. 5 zeigt ferner eine Digitallogik 52, die die Grobabstimmungseinrichtung 13 und die Feinabstimmungseinrichtung 14 umfaßt, wie es nachfolgend dargestellt wird.

Der stromgesteuerte Oszillator 10 ist bei dem in Fig. 5 gezeigten bevorzugten Ausführungsbeispiel ein stromgesteuerter Ringoszillator mit einer ungeraden Anzahl von in Kette geschalteten Invertern 51a, 51b, 51c, die von einem Stromsummenknoten 52 mit einem Betriebsstrom versorgt werden, über den eine Schwingfrequenz des stromgesteuerten Oszillators 10 einstellbar ist. Die Oszillatorsteuerungseinrichtung 11 umfaßt neben dem Stromsummenknoten 52 eine Versorgungsstromquelle 53, einen ersten Digital-Analog-Wandler 54, einen zweiten Digital-Analog-Wandler 55 und einen dritten Digital-Analog-Wandler 56. Die Digital-Analog-Wandler 54, 55 und 56 von Fig. 5 sind ausgebildet, um ausgangsseitig einen Strom zu liefern, der ein Bruchteil des eingangsseitig zugeführten Versorgungsstroms ist, wobei die Auswahl des Bruchteils über die dem Digital-Analog-Wandler über einen Digitaleingang zugeführte binäre Zahl erfolgt. Vorzugsweise werden binärgewichtete Schaltungen 54, 55 und 56 bevorzugt. Beispielsweise liefert der DAW 1 (54) den Wert des Versorgungsstroms 53 an seinem Ausgang zum Stromsummationsknoten 52, wenn alle Bits der demselben zugeführten binären Zahl gesetzt sind. Ist dagegen nur das MSB des DAW 1 (54) gesetzt, während alle Bits mit niedriger Wertigkeit gleich 0 sind, so liefert der DAW 1 ausgangsseitig die Hälfte des von der Quelle 53 gelieferten Stroms zum Stromsummationsknoten. Erfindungsgemäß werden 9-Bit-DAWs bevorzugt, obgleich in der Ausführungsform auch DAWs mit höherer bzw. niedrigerer Breite eingesetzt werden können.

Wie es aus Fig. 5 ersichtlich ist, wird der DAW 1 54 direkt von der Stromversorgung 53 versorgt. Er kann daher ausgangsseitig den maximalen Strombetrag liefern. Der DAW 1 wird bei einem bevorzugten Ausführungsbeispiel der vorliegenden Erfindung durch die Grobabstimmung und die Feinabstimmung eingestellt. Insbesondere werden die höherwertigen Bits des DAW 1 durch die Grobabstimmung eingestellt, während die niederwertigen Bits des DAW 1 durch die Feinabstimmung eingestellt werden. Der DAW 2 55 wird zur Frequenzverfolgung eingesetzt. Sein Versorgungsstrom und damit der von ihm maximal zum Stromsummationsknoten 52 lieferbare Oszillatorsteuerstrom ist durch den DAW 3 56 steuerbar. Wird der DAW 3 56 mit einem Binärwert, in dem alle Bits gesetzt sind, angesteuert, so ist der Ausgabestrom des DAW 3 56 gleich dem Versorgungsstrom 53, was unmittelbar dazu führt, daß der DAW 2, wenn er ebenfalls mit lauter Einsen beaufschlagt wird, denselben Strom zum Summationsknoten 52 liefern kann. Erfindungsgemäß wird es jedoch bevorzugt, den DAW 3 mit einer Binärzahl zu beaufschlagen, die kleiner als die maximal beaufschlagbare Binärzahl ist, um den Maximalstrom, der durch den DAW 2 55 zum Stromsummationsknoten 52 geliefert wird, zu verringern. Dieser verringerte Maximalstrom ist dann aufgrund der Tatsache, daß der DAW 2 55 ebenfalls beispielsweise mit 9 Bits beaufschlagt werden kann, feiner unterteilbar, um eine Frequenzverfolgung, zu der der DAW 2 55 eingesetzt wird, mit einer feineren Genauigkeit durchführen zu können, wie sie durch das LSB des DAW 1 bestimmt ist. Allgemein gesagt ist die Granularität des Stroms, der durch den DAW 2 ausgegeben wird, umgekehrt proportional zu dem dem DAW 2 zugeführten Betriebsstrom. Je kleiner der Betriebsstrom ist, der dem DAW 2 zugeführt wird (eingestellt durch den DAW 3), um so feiner ist die Granularität im Frequenzverfolgungsmodus, der auf den Feinabstimmungsmodus folgt.

Der digital steuerbare Oszillator 11 umfaßt somit eine Versorgungsquelle 53, den stromgesteuerten Ringoszillator 10 und die drei DAWs 54, 55 und 56. Die DAWs, die durch die Digitallogik 52 gesteuert werden, liefern den Steuerstrom zur Frequenzeinstellung des stromgesteuerten Oszillators ICO 10. Der Gesamtstrom für den ICO ist die Summe der Ströme, die von den beiden DAWs 54 und 55 geliefert werden. Die Bereiche der Digital-Analog-Wandler 1 und 2 sind vorzugsweise überlappend. Es wird bevorzugt, daß der maximale Ausgangsstrom des DAW 1 ein programmierbares Vielfaches (programmierbar durch den DAW 3) der maximalen Ausgabe des DAW 2 ist. Vorzugsweise wird ein Faktor 4 eingesetzt.

An dieser Stelle sei ferner darauf hingewiesen, daß während des Grobabstimmungsmodus und des Feinabstimmungsmodus der DAW 3 56 derart beaufschlagt wird, daß der Versorgungsstrom in dem DAW 2 um das programmierbare Vielfache kleiner ist als der Versorgungsstrom in dem DAW 1. Darüber hinaus wird bevorzugt, daß während der Grobabstimmung und der Feinabstimmung das MSB des DAW 2 gesetzt ist. Der DAW 2 liefert damit die Hälfte des von ihm insgesamt möglichen maximalen Ausgangsstroms zum Stromsummationsknoten 52. Sind dann alle Bits des DAW durch den Grobabstimmungsmodus und den Feinabstimmungsmodus eingestellt, so kann durch zusätzliches Setzen von Bits des DAW 2, die eine kleinere Wertigkeit haben als das MSB desselben, der Strom vergrößert werden. Soll der Strom im Feinabstimmungsmodus dagegen verringert werden, so wird das MSB des DAW 2 rückgesetzt und es werden je nach Bedarf die Bits niedrigerer Ordnung gesetzt oder nicht gesetzt. Dadurch, daß während des Grobabstimmungsmodus und des Feinabstimmungsmodus das MSB des DAW 2 gesetzt ist, wird sichergestellt, daß im Frequenzverfolgungsmodus, der auf den Feinabstimmungsmodus folgt, der Versorgungsstrom für den stromgesteuerten Oszillator sowohl erhöht als auch verringert werden kann.

Die Digitallogik 52 in Fig. 5 umfaßt folgende grundsätzliche Funktionsblöcke. Zunächst umfaßt die Schaltung einen Synchronisationsfelddetektor 520, der in Fig. 5 auch mit SD bezeichnet ist. Die Digitallogik umfaßt ferner einen Datenwiederherstellungsblock 521, einen Rahmenstart-Paketidentifikationsdetektor (SOF-PID-Detektor) 522, einen Oszillatortaktzykluszähler 523, eine Digitaloszillatorsteuerlogik 524, die in Fig. 5 auch mit Korrekturwert-Erzeugungs-Einrichtung bezeichnet ist, und ferner einen Block 525, der mit Taktweiterleitungslogik und Takt-Teiler/Vervielfacher bezeichnet ist.

Der Synchronisationsfelddetektor 520 umfaßt einen SE0-Detektor, einen Synchronisationsdetektor, eine Zustandsmaschine sowie einen eigenen Zähler. Der Block 520 ist mit den Differenz-Signalen Dp und Dm des USB-Busses verbunden. Der Block 520 ist wirksam, um Signale auf dem Bus abzuhören und damit den Busverkehr zu überwachen, um unter Verwendung des SE0-Detektors bestimmte Busbedingungen, wie z. B. das Vorliegen von "Single Ended Zero" zu erfassen. Im SE0-Modus sind sowohl Dp als auch Dm auf demselben Zustand, wie z. B. hoch. Nachdem Dp und Dm per Definition eigentlich Differenzsignale sind, ist der SE0-Zustand eigentlich ein verbotener Zustand, der keine aussagefähigen Nutzdaten enthält. Gemäß der USB-Spezifikation wird ein Zustand SE0 jedoch dann eingesetzt, wenn das Ende eines Pakets erreicht ist. Der SE0-Detektor erfaßt somit das Ende eines vorausgehenden Pakets und damit auch den Beginn eines Synchronisationsfelds, das der Synchronisationsdetektor dann ansprechend auf den SE0-Detektor detektiert. Nachdem eine SE0-Bedingung im Block 520 erfaßt worden ist, wird die Zustandsmaschine im Block 520 aktiviert, um auf den Empfang eines Synchronisationsmusters, wie es in Fig. 7a dargestellt ist, zu warten. Der Zähler im Block 520 mißt die Länge des Synchronisationsmusters durch Zählen der Anzahl von Oszillatorperioden zwischen dem Beginn und dem Ende des Synchronisationsfeldes.

Der Data-Recovery-Block 521 wird durch den Block 520 über die mit EN bezeichnete Leitung aktiviert oder "enabled", nachdem der Block 520 ein gültiges Synchronisationsmuster empfangen hat. Die Data-Recovery-Einheit 521 wird wieder deaktiviert, wenn der Block 520 einen Zustand SE0 empfangen hat. Darüber hinaus wird das Meßergebnis vom Block 520 bezüglich der Länge des Synchronisationsfeldes dem Block 521 zugeführt, der diese Information dazu verwendet, um "Nullen" und "Einsen" aus dem seriellen USB-Datenstrom zu extrahieren, also den Datenstrom zu decodieren bzw. in dem Datenstrom enthaltene Informationen wiederzugewinnen. Immer wenn eine gültige "0" oder eine gültige "1" von dem Block 521 erkannt worden ist, wird diese an dem Ausgang des Blocks 521 signalisiert, derart, daß der Block 521 eine Folge von Nullen bzw. Einsen liefert.

Der Rahmenstart-Paketidentifikations-Detektor 521, der auch als SOF-Token-Detektor bezeichnet wird, untersucht den seriellen Datenstrom vom Block 521 und signalisiert dem Zähler 523, wenn er eine Rahmenstart-Paketidentifikationsnummer (SOF-PID) erfaßt hat.

Der Oszillatortaktzykluszähler 523 zählt die Anzahl der DCO-Perioden zwischen dem Empfang aufeinanderfolgenden SOF-Tokens. Darüber hinaus umfaßt der Zähler 523 eine Plausibilitätsüberprüfungseinrichtung, die untersucht, ob SOF-Tokens verfehlt worden sind. Die Plausibilitätsüberprüfungseinrichtung ist ausgebildet, um einen groben Zählwert mit einem aktuellen Zählwert zu vergleichen. Übersteigt der aktuelle Zählwert den groben Zählwert um einen sehr hohen Betrag, so deutet dies darauf hin, daß wenigstens eine SOF-PID zwischen zwei erfaßten SOF-PIDs verfehlt worden ist. In diesem Fall wird der Zähler 523 dahingehend gesteuert, daß dieser Zählwert nicht der Einrichtung 524 zur Verfügung gestellt wird, da dies zu einer starken Fehleinstellung des steuerbaren Oszillators führen würde. Statt dessen wird dieser Zählwert als nicht plausibel markiert und verworfen.

Die Korrekturwert-Erzeugungs-Einrichtung 524 führt die Frequenzabstimmung und Frequenzverfolgung durch. Nach einem Reset ist der Frequenzabstimmungsalgorithmus aktiv. Zunächst wird die Frequenz des Oszillators grob abgestimmt. Zur Grobabstimmung wird die Zyklusanzahl des Synchronisationsmusters verwendet, die durch den Block 520 gemessen worden ist. Die Grobabstimmung bestimmt die höchstwertigen Bits des DAW 1, wie es ausgeführt worden ist. Mit jedem Abstimmschritt werden die niederwertigen Bits nach und nach bestimmt. Nach einer bestimmten Anzahl C von Grobabstimmungsschritten, wobei bei einer Bitbreite des DAW 1 von 9 drei Schritte für die Grobabstimmung bevorzugt werden, startet der Feinabstimmungsalgorithmus aktiviert durch eine in Fig. 1 dargestellte Steuerungseinrichtung, die die Schrittfolge der Grobabstimmung, Feinabstimmung und Frequenzverfolgung prinzipiell steuert.

Wenn die Breite des DAW 1 D1 Bits beträgt, beträgt die Anzahl der Feinabstimmungsschritte D1 - C.

Wie es ausgeführt worden ist, findet nach der Feinabstimmung die Frequenzverfolgung statt. Wie beim Feinabstimmungsalgorithmus wird auch bei der Frequenzverfolgung der Zykluszählwert des Zählers 521 eingesetzt, um die Oszillatorfrequenz über den DAW 2 55 weiter einzustellen.

Nachfolgend wird auf Fig. 6 Bezug genommen, um die Funktionalität der Korrekturwert-Erzeugungs-Einrichtung 524 detaillierter darzustellen.

In einem ersten Schritt 60 wird das höchstwertige Bit des DAW 1 gleich 1 gesetzt, während die restlichen Bits auf 0 gesetzt werden. Das MSB des DAW 2 wird während der ganzen Grob- und Feinabstimmung ebenfalls gesetzt, während die restlichen Bits des DAW 2 gleich 0 sind. In einem Schritt 61 führt die Einrichtung 524 anhand der Eingabewerte des Blocks SD 520 für die Grobabstimmung oder des Zählers 523 für die Feinabstimmung einen Frequenzvergleich durch. Ist die Frequenz zu groß, wird das MSB des DAW 1 gleich 0 gesetzt. Ist die Frequenz dagegen zu klein, bleibt das MSB des DAW 1 auf 1. Dann ist die Einrichtung 524 wirksam, um in einem Schritt 62 nunmehr das MSB-1 des DAW 1 zu setzen, nachdem das MSB derart ist, wie es im Schritt 61 bestimmt worden ist.

In einem Schritt 63 ist die Einrichtung 524 wieder wirksam, um einen Frequenzvergleich durchzuführen. Ist die Frequenz zu groß, so wird das Bit MSB-1 des DAW 1 auf 0 zurückgesetzt. Ist die Frequenz dagegen zu klein, so bleibt das Bit MSB-1 des DAW 1 auf seinem gesetzten Wert, d. h. auf 1. Auf diese Art und Weise der sukzessiven iterativen Approximation wird fortgeschritten, bis eine entsprechende vorbestimmte Anzahl von Bits des DAW 1 gesetzt ist. Dann wird durch die Steuerung 15 von Fig. 1 die Korrekturwert-Erzeugungs-Einrichtung 524 aktiviert, um vom Grobabstimmungsmodus in den Feinabstimmungsmodus zu gehen und nunmehr nicht mehr aufgrund der Zählwerte des Blocks 520 sondern aufgrund der Zählwerte des Blocks 523 zu arbeiten, um im Feinabstimmungsmodus die restlichen Bits des DAW 1 nach und nach zu berechnen.

Wenn schließlich alle Bits des DAW 1 berechnet sind (64), wird in den Frequenzverfolgungsmodus (65) geschaltet, in dem die Bits des DAW 2 entsprechend eingestellt werden. Wird im letzten Schritt 64 des Feinabstimmungsmodus festgestellt, daß die Frequenz zu klein war, so deutet dies darauf hin, daß das MSB des DAW 2, das zu Anfang im Schritt 60 auf 1 gesetzt wurde, zu Recht auf 1 ist. Wird dagegen im letzten Schritt 64 des Feinabstimmungsmodus festgestellt, daß die Frequenz zu groß ist, so wird das MSB des DAW 2 auf 0 gesetzt und die sukzessive Approximation mit dem MSB -1 des DAW 2 nach und nach durchgeführt. Je nach Ausführungsform kann zu bestimmten Zeitpunkten der DAW 3 umprogrammiert werden, um den Maximalausgabestrom und damit die Granularität des DAW 2 einzustellen bzw. an sich wechselnde Gegebenheiten anzupassen.

Abhängig von den Gegebenheiten kann das erfindungsgemäße Verfahren zum Extrahieren einer einem Datenstrom zugrundeliegenden Taktfrequenz in Hardware oder in Software implementiert werden. Die Implementation kann auf einem digitalen Speichermedium, insbesondere einer Diskette oder CD, mit elektronisch auslesbaren Steuersignalen erfolgen, die so mit einem programmierbaren Computersystem zusammenwirken können, daß das entsprechende Verfahren ausgeführt wird. Allgemein besteht die Erfindung somit auch in einem Computer-Programm-Produkt mit auf einem maschinenlesbaren Träger gespeichertem Programmcode zur Durchführung des erfindungsgemäßen Verfahrens, wenn das Computer-Programm-Produkt auf einem Rechner abläuft. In anderen Worten ausgedrückt kann die Erfindung somit als ein Computer-Programm mit einem Programmcode zur Durchführung des Verfahrens realisiert werden, wenn das Computer-Programm auf einem Computer abläuft.

## Patentansprüche

1. Vorrichtung zum Extrahieren einer einem Datenstrom zugrundeliegenden Taktfrequenz, wobei der Datenstrom in regelmäßigen, mit einer relativen ersten Genauigkeit spezifizierten ersten zeitlichen Abständen ein erstes Datenmuster (SOF-PID) aufweist, und wobei der Datenstrom ferner ein zweites Datenmuster (SYNC-Feld) aufweist, das eine Mehrzahl von Taktperioden mit der Taktfrequenz oder einem Vielfachen der Taktfrequenz aufweist, wobei die Taktperioden mit einer zweiten relativen Genauigkeit spezifiziert sind, die kleiner als die erste relative Genauigkeit ist, mit folgenden Merkmalen:
einer Einrichtung (11) zum Steuern eines steuerbaren Oszillators zum Liefern eines Oszillatortakts mit einer Oszillatortaktfrequenz;
einer Grobabstimmungseinrichtung (13), die ausgebildet ist,
um unter Verwendung des zweiten Datenmusters und einer Anzahl von Taktperioden des Oszillators die Einrichtung zum Steuern des Oszillators anzusteuern, um dessen Oszillatortaktfrequenz zu verringern, oder um die Oszillatortaktfrequenz zu erhöhen (132); und
einer Feinabstimmungseinrichtung (14), die wirksam ist, nachdem die Grobabstimmungseinrichtung wirksam war, und die ausgebildet ist,
um unter Verwendung eines ersten Datenmusters und eines zeitlich folgenden ersten Datenmusters und einer Anzahl von Taktperioden des Oszillators zwischen dem ersten Datenmuster und dem zeitlich folgenden ersten Datenmuster die Einrichtung (11) zum Steuern des Oszillators anzusteuern, um dessen Oszillatortaktfrequenz zu verringern, oder um dessen Oszillatortaktfrequenz zu erhöhen (142),
wodurch eine Oszillatortaktfrequenz mit der relativen zweiten Genauigkeit erhalten wird, die gleich der dem Datenstrom zugrundeliegenden Taktfrequenz oder gleich einem Vielfachen oder einem Bruchteil der dem Datenstrom zugrundeliegenden Taktfrequenz ist,
wobei die Oszillatorsteuerung (11) einen Digital-Analog-Wandler aufweist,
wobei der Digital-Analog-Wandler (54) eingangsseitig mit einer binären Zahl einer Breite von n Bits beaufschlagbar ist, wobei eine von dem Digital-Analog-Wandler ausgangsseitig gelieferte Steuergröße dem steuerbaren Oszillator (10) zuführbar ist,
wobei die Grobabstimmungseinrichtung (524) ausgebildet ist, um iterativ und ausgehend von einem höchstwertigen Bit eine vorbestimmte Anzahl von dem höchstwertigen Bit folgenden niederwertigen Bits zu bestimmen, wobei die vorbestimmte Anzahl kleiner als n ist, und
wobei die Feinabstimmungseinrichtung ausgebildet ist, um iterativ und ausgehend von einem Bit, dessen Wertigkeit kleiner als ein durch die Grobabstimmungseinrichtung bestimmtes niederstwertige Bit ist, restliche Bits des Digital-Analog-Wandlers zu bestimmen.

2. Vorrichtung nach Anspruch 1, bei der die Grobabstimmungseinrichtung ausgebildet ist,
um einen Beginn und ein Ende des zweiten Datenmusters zu detektieren (130),
um eine Anzahl von Taktperioden des Oszillators in einer Zeitdauer von dem Beginn zu dem Ende des zweiten Datenmusters zu zählen (131), und
um in dem Fall, in dem die gezählte Anzahl größer als ein Referenzwert ist, die Einrichtung zum Steuern des Oszillators anzusteuern, um dessen Oszillatortaktfrequenz zu verringern, oder um in dem Fall, in dem die gezählte Anzahl kleiner als der Referenzwert ist, die Einrichtung zum Steuern des Oszillators anzusteuern, um die Oszillatortaktfrequenz zu erhöhen (132).

3. Vorrichtung nach Anspruch 1 oder 2, bei der die Feinabstimmungseinrichtung ausgebildet ist,
um ein erstes Datenmuster und ein zeitlich folgendes erstes Datenmuster zu detektieren (140),
um eine Anzahl von Taktperioden des Oszillators zwischen dem ersten Datenmuster und dem zeitlich folgenden ersten Datenmuster zu zählen (141), und
um in dem Fall, in dem die gezählte Anzahl größer als ein Referenzwert ist, die Einrichtung (11) zum Steuern des Oszillators anzusteuern, um dessen Oszillatortaktfrequenz zu verringern, oder um in dem Fall, in dem die gezählte Anzahl kleiner als der Referenzwert ist, die Einrichtung (11) zum Steuern des Oszillators anzusteuern, um dessen Oszillatortaktfrequenz zu erhöhen (142)

4. Vorrichtung nach einem der vorhergehenden Ansprüche,
bei der die Grobabstimmungseinrichtung ausgebildet ist, um iterativ zu arbeiten, und ferner ausgebildet ist, um in einem Iterationsschritt nach einer Frequenzverringerung oder Frequenzerhöhung erneut einen Beginn und ein Ende des zweiten Datenmusters zu detektieren, die Anzahl von Taktperioden zu zählen und den Oszillator anzusteuern.

5. Vorrichtung nach Anspruch 4, bei der die Grobabstimmungseinrichtung ausgebildet ist, um in einem ersten Iterationsschritt den steuerbaren Oszillator so anzusteuern, dass sich seine Frequenz um eine erste vorbestimmte Differenzfrequenz verändert, und um in einem weiteren Iterationsschritt den steuerbaren Oszillator zu anzusteuern, dass sich seine Frequenz um eine zweite vorbestimmte Differenzfrequenz verändert, wobei die zweite vorbestimmte Differenzfrequenz kleiner als die erste vorbestimmte Differenzfrequenz ist.

6. Vorrichtung nach einem der vorhergehenden Ansprüche, bei der die Feinabstimmungseinrichtung ausgebildet ist, um iterativ zu arbeiten, und ferner ausgebildet ist, um in einem weiteren Iterationsschritt nach einer Frequenzverringerung oder Frequenzerhöhung erneut ein Beginn und ein Ende des zweiten Datenmusters zu detektieren, die Anzahl von Taktperioden zu zählen und den Oszillator anzusteuern.

7. Vorrichtung nach einem der vorhergehenden Ansprüche, bei der die Feinabstimmungseinrichtung ausgebildet ist, um in einem ersten Iterationsschritt den steuerbaren Oszillator so anzusteuern, dass sich seine Frequenz um eine erste vorbestimmte Differenzfrequenz verändert, und um in einem weiteren Iterationsschritt den steuerbaren Oszillator so anzusteuern, dass sich seine Frequenz um eine zweite vorbestimmte Differenzfrequenz verändert, wobei die zweite vorbestimmte Differenzfrequenz kleiner als die erste vorbestimmte Differenzfrequenz ist.

8. Vorrichtung nach einem der Ansprüche 4 bis 7, bei der die Differenzfrequenz binär gewichtet ist und eine Differenzfrequenz immer halb so groß wie eine vorausgehende Differenzfrequenz ist.

9. Vorrichtung nach einem der vorhergehenden Ansprüche, bei der der Digital-Analog-Wandler (54) eingangsseitig mit einer binären Zahl einer Breite von n Bits beaufschlagbar ist, mit einer elektrischen Eingangsgröße (53) versorgbar ist und
wobei ein Betrag eines Ausgangssignals des ersten Digital/Analog-Wandlers gleich einem Verhältnis ist, das durch die binäre Zahl und die elektrische Eingangsgröße festgelegt ist.

10. Vorrichtung nach Anspruch 9,
bei der ein weiterer Digital-Analog-Wandler (55) vorgesehen ist, der durch eine elektrische Eingangsgröße versorgbar ist, die kleiner als die elektrische Eingangsgröße ist, mit der der eine Digital-Analog-Wandler (54) versorgt wird,
wobei ein höchstwertiges Bit des weiteren Digital-Analog-Wandlers (55) während eines Bestimmens von Bits des einen Digital-Analog-Wandlers (54) durch die Grobabstimmungseinrichtung und die Feinabstimmungseinrichtung gesetzt ist.

11. Vorrichtung nach Anspruch 10, bei der die Oszillatorsteuerungseinrichtung (11) einen dritten Digital-Analog-Wandler (56) aufweist, der ausgebildet ist, um die elektrische Eingangsgröße für den weiteren Digital-Analog-Wandler (55) zu liefern, wobei der dritte Digital-Analog-Wandler mit derselben elektrischen Eingangsgröße beaufschlagbar ist, mit der der eine Digital-Analog-Wandler (54) beaufschlagbar ist, und wobei der dritte Digital-Analog-Wandler mit einer binären Zahl eingangsseitig belegbar ist, die bewirkt, dass die elektrische Eingangsgröße für den weiteren Digital-Analog-Wandler kleiner als die elektrische Eingangsgröße für den einen Digital-Analog-Wandler ist.

12. Verfahren zum Extrahieren einer einem Datenstrom zugrundeliegenden Taktfrequenz, wobei der Datenstrom in regelmäßigen, mit einer relativen ersten Genauigkeit spezifizierten ersten zeitlichen Abständen ein erstes Datenmuster (SOF-PID) aufweist, und wobei der Datenstrom ferner ein zweites Datenmuster (SYNC-Feld) aufweist, das eine Mehrzahl von Taktperioden mit der Taktfrequenz oder einem Vielfachen der Taktfrequenz aufweist, wobei die Taktperioden mit einer zweiten relativen Genauigkeit spezifiziert sind, die kleiner als die erste relative Genauigkeit ist, mit folgenden Schritten:
Steuern eines steuerbaren Oszillators zum Liefern eines Oszillatortakts mit einer Oszillatortaktfrequenz unter Verwendung eines Grobabstimmungsschritts und eines Feinabstimmungsschritts,
wobei der Grobabstimmungsschritt ausgebildet ist, um unter Verwendung des zweiten Datenmusters und einer Anzahl von Taktperioden des Oszillators die Oszillatortaktfrequenz zu verringern oder zu erhöhen; und
wobei der Feinabstimmungsschritt (14), der auf den Grobabstimmungsschritt folgt, ausgebildet ist, um unter Verwendung eines ersten Datenmusters und eines zeitlich folgenden ersten Datenmusters und einer Anzahl von Taktperioden des Oszillators zwischen dem ersten Datenmuster und dem zeitlich folgenden ersten Datenmuster die Oszillatortaktfrequenz zu verringern oder zu erhöhen,
wodurch eine Oszillatortaktfrequenz mit der relativen zweiten Genauigkeit erhalten wird, die gleich der dem Datenstrom zugrundeliegenden Taktfrequenz oder gleich einem Vielfachen oder einem Bruchteil der dem Datenstrom zugrundeliegenden Taktfrequenz ist,
wobei zur Oszillatorsteuerung ein Digital-Analog-Wandler vorhanden ist, wobei der Digital-Analog-Wandler (54) eingangsseitig mit einer binären Zahl einer Breite von n Bits beaufschlagbar ist, wobei eine von dem Digital-Analog-Wandler ausgangsseitig gelieferte Steuergröße dem steuerbaren Oszillator (10) zuführbar ist,
wobei im Grobabstimmungsschritt (524) iterativ und ausgehend von einem höchstwertigen Bit eine vorbestimmte Anzahl von dem höchstwertigen Bit folgenden niederwertigen Bits bestimmt werden, wobei die vorbestimmte Anzahl kleiner als n ist, und
wobei im Feinabstimmungsschritt iterativ und ausgehend von einem Bit, dessen Wertigkeit kleiner als ein durch die Grobabstimmungseinrichtung bestimmtes niederstwertige Bit ist, restliche Bits des Digital-Analog-Wandlers bestimmt werden.

13. Computer-Programm mit einem Programmcode zum Durchführen des Verfahrens zum Extrahieren gemäß Patentanspruch 12, wenn das Computer-Programm auf einem Computer abläuft.

## Claims

1. Device for extracting a clock frequency underlying a data stream, wherein the data stream comprises a first data pattern (SOF-PID) at regular first temporal intervals specified with a relative first accuracy, and wherein the data stream further comprises a second data pattern (SYNC field) comprising a plurality of clock periods with the clock frequency or a multiple of the clock frequency, wherein the clock periods are specified with a second relative accuracy smaller than the first relative accuracy, comprising:
means (11) for controlling a controllable oscillator for providing an oscillator clock with an oscillator clock frequency;
a coarse-tuning means (13), implemented
in order to control means for controlling the oscillator using the second data pattern and a number of clock periods of the oscillator in order to reduce its oscillator clock frequency or to increase (132) the oscillator clock frequency; and
a fine-tuning means (14) operable after the coarse-tuning means was operable and implemented
in order to control means (11) for controlling the oscillator using a first data pattern and a temporally subsequent first data pattern and a number of clock periods of the oscillator between the first data pattern and the temporally following first data pattern in order to reduce its oscillator clock frequency or to increase its oscillator clock frequency (142),
whereby an oscillator clock frequency is obtained with the relative second accuracy which is equal to the clock frequency underlying the data stream or equal to a multiple or a fraction of the clock frequency underlying the data stream,
wherein the oscillator control (11) comprises a digital-analog converter,
wherein the digital-analog converter (54) may be supplied on the input side with a binary number of a width of n bits, wherein a control quantity provided by the digital-analog converter on the output side may be supplied to the controllable oscillator (10),
wherein the coarse-tuning means (524) is implemented in order to determine a predetermined number of less significant bits following the most significant bit in an iterative way and based on the most significant bit, wherein the predetermined number is smaller than n, and
wherein the fine-tuning means is implemented in order to determine, iteratively and based on a bit the order of which is smaller than a least significant bit determined by the coarse-tuning means, remaining bits of the digital-analog converter.

2. Device according to claim 1, wherein the coarse-tuning means is implemented
to detect a beginning and an end of the second data pattern (130),
to count a number of clock periods of the oscillator in a time duration from the beginning to the end of the second data pattern (131), and
in the case in which the counted number is larger than a reference value, to control the means for controlling the oscillator in order to reduce its oscillator clock frequency, or in the case in which the counted number is smaller than the reference value, to control the means for controlling the oscillator in order to increase the oscillator clock frequency (132).

3. Device according to claim 1 or 2, wherein fine-tuning means is implemented
to detect a first data pattern and a temporally following first data pattern (140),
to count a number of clock periods of the oscillator between the first data pattern and the temporally following first data pattern (141), and
in the case in which the counted number is larger than a reference value, to control means (11) for controlling the oscillator in order to reduce its oscillator clock frequency, or in the case in which the counted number is smaller than the reference value, to control means (11) for controlling the oscillator in order to increase its oscillator clock frequency (142).

4. Device according to one of the preceding claims,
wherein the coarse-tuning means is implemented in order to operate iteratively and is further implemented in order to detect again a beginning and an end of the second data pattern, to count the number of clock periods, and to control the oscillator in an iteration step after a frequency decrease or frequency increase.

5. Device according to claim 4, wherein the coarse-tuning means is implemented in order to control the controllable oscillator in a first iteration step so that its frequency changes by a first predetermined differential frequency and in order to control the controllable oscillator in a further iteration step so that the frequency changes by a second predetermined differential frequency, wherein the second predetermined differential frequency is smaller than the first predetermined differential frequency.

6. Device according to one of the preceding claims, wherein the fine-tuning means is implemented in order to operate iteratively and is further implemented in order to detect again a beginning and an end of the second data pattern, to count the number of clock periods, and to control the oscillator in a further iteration step after a frequency decrease or frequency increase.

7. Device according to one of the preceding claims, wherein the fine-tuning means is implemented in order to control the controllable oscillator in a first iteration step so that its frequency changes by a first predetermined differential frequency, and in order to control the controllable oscillator in a further iteration step so that its frequency changes by a second predetermined differential frequency, wherein the second predetermined differential frequency is smaller than the first predetermined differential frequency.

8. Device according to one of claims 4 to 7, wherein the differential frequency is binarily weighted and a differential frequency is always half the size of a preceding differential frequency.

9. Device according to one of the preceding claims, wherein the digital-analog converter (54) may be supplied on the input side with a binary number of a width of n bits, may be supplied with an electric input quantity (53), and
wherein a magnitude of an output signal of the first digital/analog converter is equal to a ratio determined by the binary number and the electric input quantity.

10. Device according to claim 9,
wherein a further digital-analog converter (55) is provided, which may be supplied with an electric input quantity smaller than the electric input quantity the one digital-analog converter (54) is supplied with,
wherein a most significant bit of the further digital-analog converter (55) is set during the determination of bits of the one digital-analog converter (54) by the coarse-tuning means and the fine-tuning means.

11. Device according to claim 10, wherein the oscillator control means (11) comprises a third digital-analog converter (56) which is implemented in order to provide the electric input quantity for the further digital-analog converter (55), wherein the third digital-analog converter may be supplied with the same electric input quantity with which the one digital-analog converter (54) may be supplied, and wherein the third digital-analog converter may be occupied with a binary number on the input side which causes the electric input quantity for the further digital-analog converter to be smaller than the electric input quantity for the one digital-analog converter.

12. Method for extracting a clock frequency underlying a data stream, wherein the data stream comprises a first data pattern (SOF-PID) in regular first temporal intervals specified with a relative first accuracy, and wherein the data stream further comprises a second data pattern (SYNC field) comprising a plurality of clock periods with the clock frequency or a multiple of the clock frequency, wherein the clock periods are specified with a second relative accuracy which is smaller than the first relative accuracy, comprising the steps of:
controlling a controllable oscillator for providing an oscillator clock with an oscillator clock frequency using a coarse-tuning step and a fine-tuning step,
wherein the coarse-tuning step is implemented to decrease or increase the oscillator clock frequency using the second data pattern and a number of clock periods of the oscillator; and
wherein the fine-tuning step (14) following the coarse-tuning step is implemented to decrease or increase the oscillator clock frequency using a first data pattern and a temporally following first data pattern and a number of clock periods of the oscillator between the first data pattern and the temporally following first data pattern,
whereby an oscillator clock frequency with the relative second accuracy is obtained which is equal to the clock frequency underlying the data stream or equal to a multiple or a fraction of the clock frequency underlying the data stream,
wherein a digital-analog converter is present for oscillator control, wherein the digital-analog converter (54) may be supplied on the input side with a binary number of a width of n bits, wherein a control quantity provided by the digital-analog converter on the output side may be supplied to the controllable oscillator (10),
wherein in the coarse-tuning step (524) a predetermined number of less significant bits following the most significant bit are determined in an iterative way and based on the most significant bit, wherein the predetermined number is smaller than n, and
wherein in the fine-tuning step, iteratively and based on a bit the order of which is smaller than a least significant bit determined by the coarse-tuning means, remaining bits of the digital-analog converter are determined.

13. Computer program having a program code for performing the method for extracting according to claim 12 when the computer program runs on a computer.

## Revendications

1. Dispositif pour extraire une fréquence d'horloge à la base d'un flux de données, le flux de données présentant, à des intervalles de temps réguliers spécifiés avec une première précision relative, un premier modèle de données (SOF-PID), et le flux de données présentant, par ailleurs, un deuxième modèle de données (champ SYNC) présentant une pluralité de périodes de cycle d'horloge à la fréquence d'horloge ou un multiple de la fréquence d'horloge, les périodes de cycle d'horloge étant spécifiées avec une deuxième précision relative qui est inférieure à la première précision relative, aux caractéristiques suivantes :
un dispositif (11) destiné à régler un oscillateur réglable destiné à fournir un cycle d'horloge d'oscillateur avec une fréquence d'horloge d'oscillateur ;
un dispositif de réglage approximatif (13) qui est réalisé
de manière à activer, à l'aide du deuxième modèle de données et d'un nombre de périodes de cycle d'horloge de l'oscillateur, le dispositif destiné à régler l'oscillateur, pour réduire sa fréquence d'horloge d'oscillateur, ou pour augmenter la fréquence d'horloge d'oscillateur (132) ; et
un dispositif de réglage fin (14) qui est actif, après qu'était actif le dispositif de réglage approximatif, et qui est réalisé
de manière à activer le dispositif (11) destiné à régler l'oscillateur à l'aide d'un premier modèle de données et d'un premier modèle de données successif dans le temps et d'un nombre de périodes de cycle d'horloge de l'oscillateur entre le premier modèle de données et le premier modèle de données successif dans le temps, pour réduire sa fréquence d'horloge d'oscillateur, ou pour augmenter sa fréquence d'horloge d'oscillateur (142),
d'où est obtenue une fréquence d'horloge d'oscillateur avec la deuxième précision relative qui est égale à la fréquence d'horloge à la base du flux de données ou égale à un multiple ou une fraction de la fréquence d'horloge à la base du flux de données,
la commande d'oscillateur (11) présentant un convertisseur numérique-analogique,
le convertisseur numérique-analogique (54) pouvant être soumis, du côté de l'entrée, à un nombre binaire d'une largeur de n bits, une grandeur de réglage fournie du côté de la sortie par le convertisseur numérique-analogique pouvant être alimentée vers l'oscillateur réglable (10),
le dispositif de réglage approximatif die (524) étant réalisé de manière à déterminer, de manière itérative et partant d'un bit à la valeur la plus élevée, un nombre prédéterminé de bits de valeur inférieure suivant le bit à la valeur la plus élevée, le nombre prédéterminé étant inférieur à n, et
le dispositif de réglage fin étant réalisé de manière à déterminer, de manière itérative et partant d'un bit dont la valence est inférieure à un bit de valeur inférieure déterminé par le dispositif de réglage approximatif, les bits restants du convertisseur numérique-analogique.

2. Dispositif selon la revendication 1, dans lequel le dispositif de réglage approximatif est réalisé de manière à
détecter un début et une fin du deuxième modèle de données (130),
compter un nombre de périodes de cycle d'horloge de l'oscillateur dans un laps de temps du début à la fin du deuxième modèle de données (131), et
au cas où le nombre compté est supérieur à une valeur de référence, activer le dispositif destiné à régler l'oscillateur, pour réduire sa fréquence de cycle d'oscillateur, ou, au cas où le nombre compté est inférieur à une valeur de référence, activer le dispositif destiné à régler l'oscillateur, pour augmenter sa fréquence de cycle d'oscillateur (132).

3. Dispositif selon la revendication 1 ou 2, dans lequel le dispositif de réglage fin est réalisé de manière à
détecter un premier modèle de données et un premier modèle de données successif dans le temps (140),
compter un nombre de périodes de cycle d'horloge de l'oscillateur entre le premier modèle de données et le premier modèle de données successif dans le temps (141), et
au cas où le nombre compté est supérieur à une valeur de référence, activer le dispositif (11) destiné à régler l'oscillateur, pour diminuer sa fréquence d'horloge d'oscillateur ou, au cas où le nombre compté est inférieur à une valeur de référence, activer le dispositif (11) destiné à régler l'oscillateur, pour augmenter sa fréquence d'horloge d'oscillateur (142).

4. Dispositif selon l'une des revendications précédentes,
dans lequel le dispositif de réglage approximatif est réalisé de manière à fonctionner de manière réitérative, et est, par ailleurs, réalisé de manière à détecter, dans une étape d'itération après une diminution de fréquence ou une augmentation de fréquence, à nouveau un début et une fin du deuxième modèle de données, à compter le nombre de périodes de cycle d'horloge et à activer l'oscillateur.

5. Dispositif selon la revendication 4, dans lequel le dispositif de réglage approximatif est réalisé de manière à activer, dans une première étape d'itération, l'oscillateur réglable de sorte que sa fréquence varie d'une première fréquence différentielle prédéterminée et à activer, dans une autre étape d'itération, l'oscillateur réglable de sorte que sa fréquence varie d'une deuxième fréquence différentielle prédéterminée, la deuxième fréquence différentielle prédéterminée étant inférieure à la première fréquence différentielle prédéterminée.

6. Dispositif selon l'une des revendications précédentes, dans lequel le dispositif de réglage fin est réalisé de manière à fonctionner de manière réitérative et est, par ailleurs, réalisé de manière à détecter à nouveau, dans une autre étape d'itération après une diminution de fréquence ou une augmentation de fréquence, un début et une fin du deuxième modèle de données, à compter le nombre de périodes de cycle d'horloge et à activer l'oscillateur.

7. Dispositif selon l'une des revendications précédentes, dans lequel le dispositif de réglage fin est réalisé de manière à activer, dans une première étape d'itération, l'oscillateur réglable de sorte que sa fréquence varie d'une première fréquence différentielle prédéterminée et à activer, dans une autre étape d'itération, l'oscillateur réglable de sorte que sa fréquence varie d'une deuxième fréquence différentielle prédéterminée, la deuxième fréquence différentielle prédéterminée étant inférieure à la première fréquence différentielle prédéterminée,

8. Dispositif selon l'une des revendications 4 à 7, dans lequel la fréquence différentielle est pondérée de manière binaire et une fréquence différentielle est toujours de la moitié d'une fréquence différentielle précédente.

9. Dispositif selon l'une des revendications précédentes, dans lequel le convertisseur numérique-analogique (54) peut être soumis, du côté de l'entrée, à un nombre binaire d'une largeur de n bits, peut être alimenté par une grandeur d'entrée électrique (53), et
une valeur d'un signal de sortie du premier convertisseur numérique-analogique étant égale à un rapport qui est fixé par le nombre binaire et la grandeur d'entrée électrique.

10. Dispositif selon la revendication 9,
dans lequel est prévu un autre convertisseur numérique-analogique (55) qui peut être alimenté par une grandeur d'entrée électrique qui est plus petite que la grandeur d'entrée électrique par laquelle est alimenté l'un convertisseur numérique-analogique (54),
dans lequel un bit à la valeur la plus élevée de l'autre convertisseur numérique-analogique (55) est réglé, pendant une détermination de bits de l'un convertisseur numérique-analogique (54), par le dispositif de réglage approximatif et le dispositif de réglage fin.

11. Dispositif selon la revendication 10, dans lequel le dispositif de réglage d'oscillateur (11) présente un troisième convertisseur numérique-analogique (56) qui est réalisé de manière à fournir la grandeur d'entrée électrique pour le deuxième convertisseur numérique-analogique (55), le troisième convertisseur numérique-analogique pouvant être soumis à la même grandeur d'entrée électrique à laquelle peut être soumis l'un convertisseur numérique-analogique (54), et le troisième convertisseur numérique-analogique pouvant être occupé, du côté de l'entrée, par un nombre binaire qui fait que la grandeur d'entrée électrique pour l'autre convertisseur numérique-analogique soit inférieure à la grandeur d'entrée électrique pour l'un convertisseur numérique-analogique.

12. Procédé pour extraire une fréquence d'horloge à la base d'un flux de données, le flux de données présentant, à de premiers intervalles de temps réguliers spécifiés avec une première précision relative, un premier modèle de données (SOF-PID), et le flux de données présentant, par ailleurs, un deuxième modèle de données (Champ SYNC) présentant une pluralité de périodes de cycle d'horloge à la fréquence d'horloge ou un multiple de la fréquence d'horloge, les périodes de cycle d'horloge étant spécifiées avec une deuxième précision relative qui est inférieure à la première précision relative, aux étapes suivantes consistant à :
régler un oscillateur réglable destiné à fournir un cycle d'horloge d'oscillateur avec une fréquence de cycle d'horloge d'oscillateur à l'aide d'une étape de réglage approximatif et d'une étape de réglage fin,
l'étape de réglage approximatif étant réalisée de manière à réduire ou à augmenter, à l'aide du deuxième modèle de données et d'un nombre de périodes de cycle d'horloge de l'oscillateur, la fréquence d'horloge de l'oscillateur ; et
l'étape de réglage fin (14) qui suit l'étape de réglage approximatif étant réalisée de manière à réduire ou à augmenter, à l'aide d'un premier modèle de données et d'un première modèle successif dans le temps et d'un nombre de périodes de cycle d'horloge de l'oscillateur entre le premier modèle de données et le premier modèle de données successif dans le temps, la fréquence d'horloge de l'oscillateur,
d'où est obtenue une fréquence d'horloge d'oscillateur avec la deuxième précision relative qui est égale à la fréquence d'horloge à la base du flux de données ou égale à un multiple ou à une fraction de la fréquence d'horloge à la base du flux de données,
pour le réglage de l'oscillateur étant prévu un convertisseur numérique-analogique, le convertisseur numérique-analogique (54) pouvant être soumis, du côté de l'entrée, à un nombre binaire d'une largeur de n bits, une grandeur de commande fournie du côté de la sortie par le convertisseur numérique-analogique pouvant être alimentée vers l'oscillateur réglable (10),
à l'étape de réglage approximatif (524) étant déterminés, de manière itérative et partant d'un bit à la valeur la plus élevée, un nombre prédéterminé de bits de valeur inférieure suivant le bit à la valeur la plus élevée, le nombre prédéterminé étant inférieur à n, et
à l'étape de réglage fin étant déterminés, de manière itérative et partant d'un bit dont la valence est inférieure à un bit à la valeur la plus faible déterminé par le dispositif de réglage approximatif, les bits restants du convertisseur numérique-analogique.

13. Programme d'ordinateur avec un code de programme pour réaliser le procédé pour extraire selon la revendication 12 lorsque le programme d'ordinateur est exécuté sur un ordinateur.
